(19) Europäisches Patentamt
European Patent Office
Office européen des brevets

(11) EP 4 450 588 B1

(12) **EUROPEAN PATENT SPECIFICATION**

(45) Date of publication and mention of the grant of the patent:
**24.09.2025 Bulletin 2025/39**

(21) Application number: **23169190.8**

(22) Date of filing: **21.04.2023**

(51) International Patent Classification (IPC):
***C09K 11/06*** *(2006.01)* ***H10K 50/00*** *(2023.01)*

(52) Cooperative Patent Classification (CPC):
**C09K 11/06; H10K 50/15; H10K 85/636; H10K 85/6572;** H10K 2101/20

(54) **ORGANIC BIPOLAR SEMICONDUCTORS BASED ON STABLE RADICAL ACCEPTOR MOIETY FOR OPTOELECTRONIC APPLICATIONS**

ORGANISCHE BIPOLARE HALBLEITER AUF BASIS EINES STABILEN RADIKALAKZEPTOR-TEILS FÜR OPTOELEKTRONISCHE ANWENDUNGEN

SEMI-CONDUCTEURS ORGANIQUES BIPOLAIRES BASÉS SUR UNE FRACTION D'ACCEPTEUR DE RADICAUX STABLE POUR DES APPLICATIONS OPTOÉLECTRONIQUES

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(43) Date of publication of application:
**23.10.2024 Bulletin 2024/43**

(73) Proprietor: **Kaunas University of Technology**
**44029 Kaunas (LT)**

(72) Inventors:
- **Keruckiene, Rasa**
  **LT-44433 Kaunas (LT)**
- **Stanitska, Mariia**
  **LT-50240 Kaunas (LT)**
- **Grazulevicius, Juozas**
  **LT-54358 Kaunas (LT)**
- **Volyniuk, Dmytro**
  **LT-49449 Kaunas (LT)**
- **Marsalka, Arunas**
  **LT-10238 Vilnius (LT)**
- **Bezvikonnyi, Oleksandr**
  **LT-50240 Kaunas (LT)**
- **Simokaitiene, Jurate**
  **LT-49159 Kaunas (LT)**
- **Butkute, Rita**
  **LT-50436 Kaunas (LT)**
- **Dabuliene, Asta**
  **LT-54430 Kaunas (LT)**
- **Skuodis, Eigirdas**
  **LT-46446 Kaunas (LT)**

(74) Representative: **Klimaitiene, Otilija**
**AAA Law**
**A. Gostauto 40B**
**03163 Vilnius (LT)**

(56) References cited:
**CN-A- 108 191 739** **US-A1- 2019 074 449**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 4 450 588 B1

## Description

### FIELD OF THE INVENTION

The present invention relates to organic bipolar semiconductors having donor-acceptor structure, where the acceptor is implemented specifically by stable bipolar organic radicals. These semiconductors are effective for optoelectronic devices, organic light-emitting diodes (OLED), light-emitting field-effect transistors (FET), light-emitting vertical transistors (VOLET), optical and chemical sensors, memory devices, batteries, data storage devices, solar cells, photovoltaic devices, photodetectors, thermo-electric and photothermal conversion, external stress responsible probes, bio-, surface-imaging probes.

### BACKGROUND OF THE INVENTION

The development of efficient organic semiconductors is a prerequisite for the fabrication of highly efficient OLEDs and other optoelectronic devices. Despite the significant research efforts devoted to find easily synthesizable and efficient organic semiconductors, molecular design still requires complex synthesis pathways that are technologically complicated to implement (Nat. Photon. 2014, 8, 326-332, ACS Appl. Mater. Interfaces, 2016, 8, 23190-23196). The synthetic processes are usually lengthy multi-step, time-consuming and expensive.

OLEDs are used not only in the manufacture of large area, roll-up screens or lighting, flexible portable smart devices, but also in the manufacture of various biosensors. (Cryst. Growth Des. 2021, 21, 2, 1062-1076) The wide range of applications of OLEDs is due to their valuable properties such as high color brightness, low energy consumption, and relatively low production costs. In order to increase production volumes, several problems need to be solved, such as the insufficient durability and efficiency of the devices. Taking this into account, the search for the most suitable organic semiconductors remains a relevant topic.

Since the first demonstration of the doublet-emission OLED in 2015, the studies on stable radicals have attracted much attention and many advances were achieved. (Angew.Chem. Int.Ed. 2015, 54,7091 -7095). Doublet-emission OLEDs have been regarded as a promising complement to OLEDs, which possess high academic value, as well as a profound practical implication. Donor-acceptor radical systems have been demonstrated with efficient emission in the red and deep-red optical range of 600- 700 nm. Lowering the emission wavelength to green and blue colours for radical OLEDs is still challenging. For doublet emitters in the blue range, new radical moieties with intrinsically larger HOMO-LUMO gaps must be designed. The currently limited chemical space for radical $\pi$-system organic semiconductors is one of the biggest issues which must be developed by innovation in organic chemistry. This is key to having organic radical semiconductors and emitters across the full visible range that could compete with current display and lighting technologies and other optoelectronic technologies.

Luminescent and/or charge transporting stable organic radicals can display unusual electronic structures that are not only of fundamental interest but can also be exploited in applications such as information storage, solar cells, fluorescence probes or chemical sensors. Recently, they have been exploited as emitters in organic light-emitting diodes (OLEDs), with potential for industrial applications in high-end flat panel displays or light sources (Angew.Chem. (2015) 127, 7197-7201). However, so far, while there exist several types of radicals that are sufficiently stable to be isolated and stored under ambient conditions, none of them were exploited as charge transporting materials in the devices of organic optoelectronics.

The doublet-spin nature of radical emitters is advantageous for applications in organic light-emitting diodes, as it avoids the formation of triplet excitons that limit the electroluminescence efficiency of non-radical emitters. (Nature Materials, (2020) 19, 1224-1229, https://doi.org/10.1038/s41563-020-0705-9) Photoexcitation of doublet-ground-state (D0) molecules generates doublet excited states, and spin-allowed emission, i.e., fluorescence. Thus, emission in these molecules originates from the lowest-lying doublet excited state, D1. (Nature, (2018) 563, 536-540) The short emission lifetime suggests that radiative decay occurs by fluorescence that can boost device efficiency when used in the active layers of OLEDs.

In 2018, R.H. Friend et. al. (Nature, (2018) 563, 536-540) reported radical-donor type red doublet emitters which in combination with state-of-the art phosphorescent and thermally activated delayed fluorescence (TADF) emitters allowed to achieve $EQE_{max}$ of OLEDs of 27 %. Such doublet emitters contain a donor moiety and a radical group as an acceptor, which resemble the structural motif of classical thermally activated delayed fluorescence (TADF) molecules. The radicals comprise an electron that occupies the single occupied molecular orbital (SOMO) (Nat. Mater. 18, 917-918 (2019)). This electron in the SOMO is promoted to higher energy levels. It has no electron to partner with so it remains a spin S = 1/2 excitation with two possible spin configurations, referred to as doublet state (no triplets). Conceptually, doublet emitters are superior to any of the aforementioned triplet harvesting concepts as they break the spin statistics of closed-shell molecules (Nature, (2018) 563, 536-540). Despite conventional doublet emitters are known to be chemically unstable due to their radical nature, it was shown that neutral radicals in donor-acceptor structures can be obtained using the radical

unit as the acceptor (Nature, (2018) 563, 536-540). The development of luminescent radicals faces three major challenges (Nature Materials, (2020), 18, 977-984). 1) Given the absence of simple molecular-design principles, there are very limited examples of organic luminescent/charge-transporting radicals; 2) The luminescence quantum yields are generally low, of the order of 10% or lower, when the demand is to reach 70%; 3) The photostability is poor.

For the successful employment of such materials in optoelectronics, it is essential to develop innovative methods to guide the synthesis of new stable charge-transporting and/or luminescent free radicals. The difficulty in obtaining such materials is the limited radical chemistry available, with most reports involving halogenated triaryl radical moieties. One way is introduction of nonconjugated steric-hindrance groups to the radical skeleton (CCS Chem. 2020, 2, 1129-1145) For higher energy doublet emitters, materials with less delocalized $\pi$-systems should be considered, i.e., less than the three phenyl groups in triphenylmethyl radical derivatives. Frontier HOMO and LUMO $\pi$-orbitals become higher and lower in energy, respectively, because of delocalization. The larger the extent of $\pi$-delocalization, the closer the frontier $\pi$-molecular orbitals are in energy to the non-bonding SOMO level. As a result, higher energy doublet emission will be seen in systems with lower $\pi$-delocalization, such as by incorporation of a sp2 alkyl group adjacent to the trivalent radical carbon (J. Appl. Phys., (2021), 129, 180901). There are only three series of room temperature luminescent stable radicals reported so far: perchlorotriphenyl methyl (PTM) radical derivatives (J. Phys. Chem. C 2009, 113, 20958-20966.) tris(2,4,6-trichlorophenyl) methyl (TTM) radical derivatives (Mater. Chem. Front. 2017, 1, 2132-2135) and pyridyl-containing triarylmethyl radicals (PyBTM) (Chem. Commun. 2016, 52, 13393-13396). All of them have the structure of three benzene units or benzene analogues surrounding the central radical with chlorine substituents. The sp2 hybridization of the central carbon atom is beneficial to spin delocalization, the inside six chlorine atoms act as steric shields, and the outside three chlorine atoms prevent the formation of dimers (J.Org. Chem. 1998, 63, 9992-9994). It is widely accepted that steric and delocalization effects usually play critical roles in tuning the stability of organic radicals in organic optoelectronics (Org. Biomol. Chem. 2007, 5, 1321-1338; Chem. Rev. 2003, 103, 789-809.).

In principle, organic radicals may potentially show state-of-the-art electronic properties such as those exhibited by conventional organic semiconductors (Adv. Mater. 2020, 32, 1908015). For example, organic radicals demonstrated high conductivity (ACS Appl. Mater. Interfaces 2013, 5, 9896-9901), good charge injecting properties (Adv. Mater. 2013, 25, 6951-6955), and unipolar, bipolar or ambipolar charge transporting properties with high charge carrier mobilities (J. Am. Chem. Soc. 2020, 142, 38-43; J. Am. Chem. Soc. 2017, 139, 41, 14336-14339; J. Am. Chem. Soc. 2014, 136, 14658-14661; Chem. Commun., 2010, 46, 5130-5132; Org. Lett. 2019, 21, 4448-4453). Such electronic properties make them appropriate candidates as active materials of many optoelectronic devices including OLEDs, FETs, VOLETs, batteries, sensors, solar cells, photovoltaic devices, photodetectors, thermo-electric and photothermal conversion (Chem. Mater. 2017, 29, 16, 6733-6739; Adv. Funct. Mater.2021, 31, 2101981; Nanoscale Adv., 2020, 2, 1031-1035; ACS Appl. Mater. Interfaces 2021, 13, 28, 33311-33320).

The Chinese patent application CN108191739A discloses "a stable roomtemperature organic luminescent material based on benzhydryl radicals and an organic electroluminescent device prepared by using the material, belonging to the technical field of organic luminescence. The common feature the organic luminescent materials is the central carbon radical, which is composed of two C-C covalent bonds and one C-N covalent bond. Stability is the key property of luminescent free radical materials in application, and connecting electron-donating groups is beneficial to stabilizing free radicals. In the present invention, electron-donating groups such as nitrogen-containing heterocyclic carbazole, indole, and dimethylacridine The nitrogen atom in the compound is directly connected to the benzhydryl group to obtain a stable benzhydryl radical, which is much more stable than PTM and TTM, and has room temperature fluorescence. The organic electroluminescent device prepared by using the material uses doublet excitons to emit light, which can avoid the problem of using triplet excitons in traditional organic electroluminescent devices, and the maximum external quantum efficiency of the device is 0.66%".

Despite the aforementioned achievements, stable luminescent and/or charge transporting free radicals and doublet-emission devices are still in their infancy and strongly depend on the innovative approaches for developing new stable radical based organic compounds.

SUMMARY OF INVENTION

The present invention is related to donor-acceptor-type organic electroactive compounds (also called radicals; when a compound has a radical fragment, it is considered as a radical itself) (also known as bipolar organic semiconductors) formed comprising stable free radicals containing trivalent radical carbon as an acceptor in the donor-acceptor structure.

The invention is an organic bipolar semiconductor of donor-acceptor-type defined by the independent claim 1. Preferred embodiments of the invention, production methods, and uses of the organic bipolar semiconductors according to the invention are defined by the dependent claims 2 to 13.

Other compounds/embodiments, not falling into the scope of claims, are only reference/illustrative compounds that do not form part of the invention.

BRIEF DESCRIPTION OF FIGURES

**Figure 1.** depicts **a)** the general formula *(I)* of the compound according to the present invention; **b)** the general synthesis scheme of radicals **1-6.**

**Figure 2.** depicts electron paramagnetic resonance (EPR) spectra of stable radicals **1-6:**

- **a)** radical **1:** *6-(Bis(2,4-dimethylphenyl)methyl)-3',6'-di-tert-butyl-9-ethyl-9H-3,9'-bicarbazole radical;*
- **b)** radical **2:** *6-Benzhydryl-3',6'-di-tert-butyl-9-ethyl-9H-3,9'-bicarbazole radical;*
- **c)** radical **3:** *6-(Bis(2,6-dimethylphenyl)methyl)-3',6'-di-tert-butyl-9-ethyl-9H-3,9'-bicarbazole radical;*
- **d)** radical **4:** *10-(6-(Bis(2,4-dimethylphenyl)methyl)-9-ethyl-9H-carbazol-3-yl)-2, 7-di-tert-butyl-9,9-dimethyl-9, 10-dihydroacridine radical;*
- **e)** radical **5:** *10-(6-Benzhydryl-9-ethyl-9H-carbazol-3-yl)-2,7-di-tert-butyl-9,9-dimethyl-9, 10-dihydroacridine radical;*
- **f)** radical **6:** *10-(6-(Bis(2,6-dimethylphenyl)methyl)-9-ethyl-9H-carbazol-3-yl)-2,7-di-tert-butyl-9,9-dimethyl-9, 10-dihydroacridine radical.*

**Figure 3.** depicts **a)** UV-Vis absorption and emission spectra of thin and thick films of carbazole-based radical **2** and dimethylacridan-carbazole-based radical **6; b)** emission spectra of dilute toluene solutions of radicals **1-6; c)** emission spectra of THF solutions of radical **2** and its precursor (the inset shows the molecular structure of the precursor); **d)** emission spectra of the dilute toluene solution of radical **1** after different time of 365 nm UV irradiation of 1.1 $mW/cm^2$; **e)** ratio of initial ($I_0$) and later (I) emission intensities as the function of time of UV irradiation for dilute toluene solutions of radicals **1-6** (I and $I_0$ are estimated as integrated areas of the corresponding emission spectra).

**Figure 4.** depicts charge carrier mobilities of radicals 1-6.

DETAILED DESCRIPTION OF THE INVENTION

The main object of the invention is bipolar electroactive compound of donor-acceptor-type (organic semiconductor) which comprises a stable radical acceptor containing trivalent radical carbon moiety according to the general formula (I). When the donating abilities of donors are appropriate, either bipolar-charge transport, full-spectrum absorption, doublet emission, low HOMO/LUMO energy splitting can be obtained of the invented stable free radical acceptor in the formula (I):

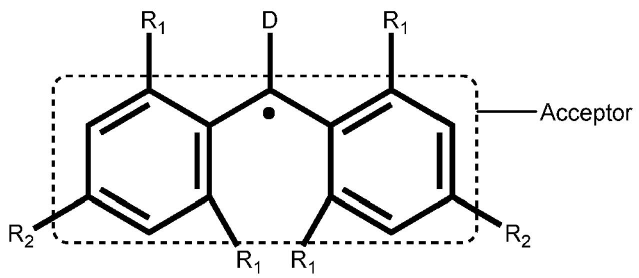

**$R_1$, $R_2$:** aliphatic or halogen substituents.

To improve the stability of free radical molecules, a common and effective approach is to shield the radical site by using bulky substituents (Org. Biomol. Chem. 2007, 5, 1321-1338; J. Am. Chem. Soc. 1971, 93, 2215-2225). The steric effect can prohibit the dimerization of free radicals effectively. It can be realized by introducing large protecting groups, mainly halogen atoms, or aliphatic substituents. In addition, for polyaromatic radical systems, the spin delocalization effect is beneficial to narrow the energy gap, decreasing the entire energy and reactivity of radical systems.

Sometimes, these two effects coexist. (CCS Chem. 2020, 2, 1129-1145). The compounds of the formula (I) are prominent for their hole and electron transport as well as for their structural advantages induced by steric effect of alkylation.

**General synthesis scheme of compounds of general formula (I).** Bipolar electroactive stable free radical containing trivalent radical carbon moiety corresponding to general formula (I) are synthesised *via* Friedel-Crafts

alkylation reaction (Angewandte Chemie International Edition, 43(5), 550-556). Aromatic amine is alkylated by the reaction with aromatic alcohol in the presence of Lewis acid (boron trifluoride diethyl ethearate) as catalyst. The reaction lasted 1 h at room temperature (RT). The following dehydrogenation is performed by adding p-chloranyl to obtain stable free radical. After the reaction is finished, the reaction mixture is filtrated through 2-cm layer of Celite®, washed with ethylacetate. All the volatiles are removed under vacuum and the products are recrystallized from methanol. The general synthesis scheme of compounds **1-6** is presented in Figure 1.

**Embodiment compounds of the general formula (I).** According to a further embodiment, the bipolar organic light-emitting semiconductors containing stable radical acceptor of the invention of formula (I) is selected from, but not limited to, a compound according to any one of the formulae (1) to (105), wherein the selectable group according to the invention comprises the following compounds (42 from the 105 formulae list): from 1 to 9, and from 62 to 94:

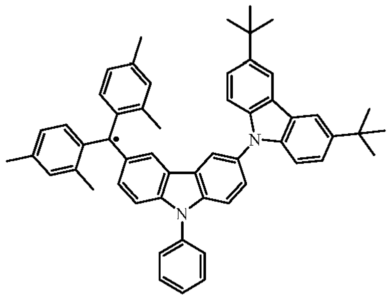

10

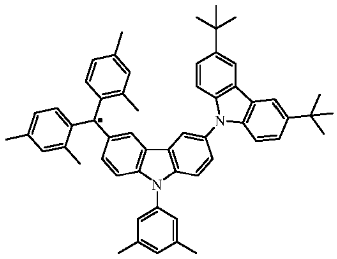

11

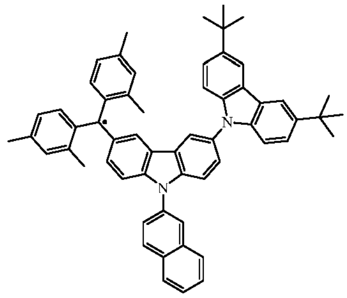

12

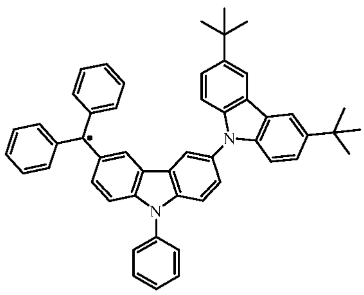

13

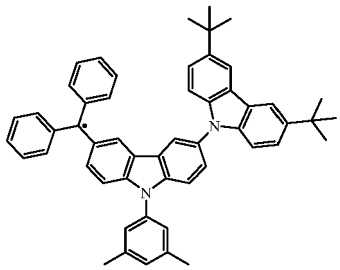

14

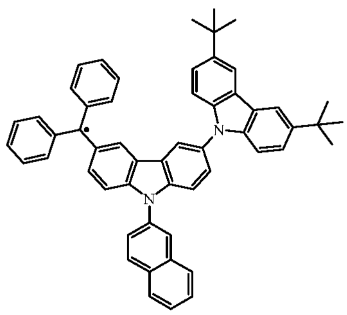

15

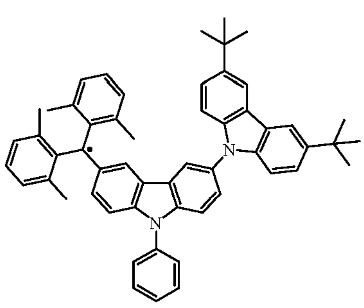

16

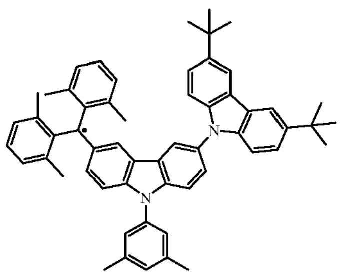

17

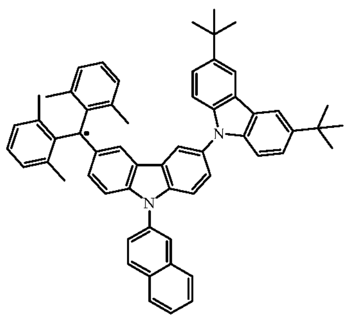

18

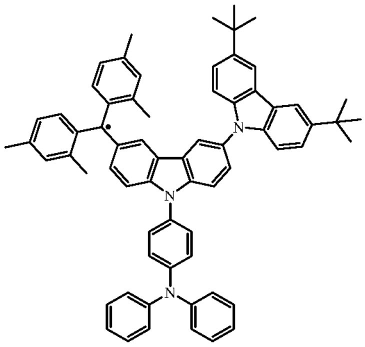

19

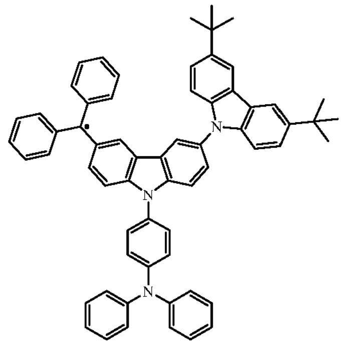

20

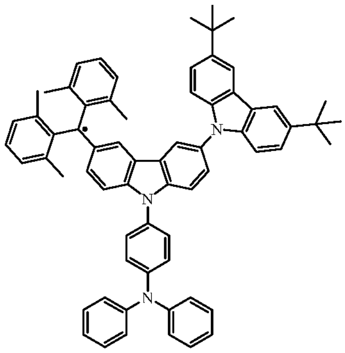

21

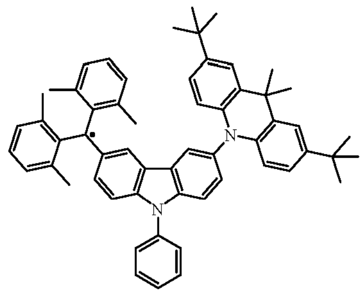

22

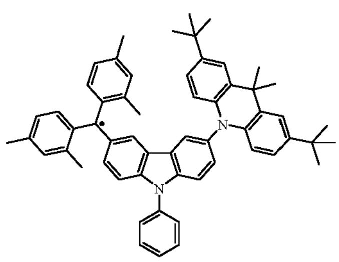

23

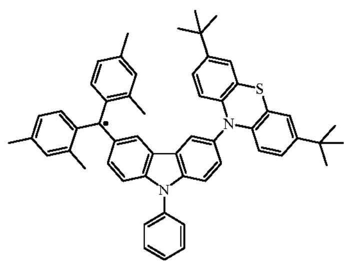

24

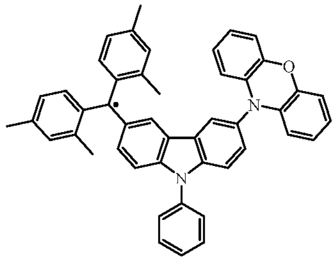

25

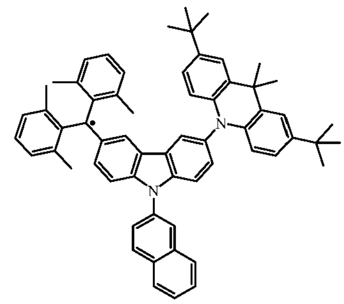

26

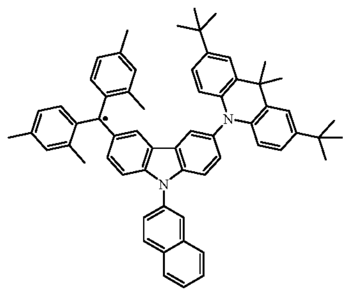

27

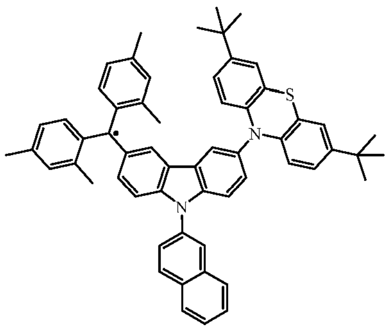

28

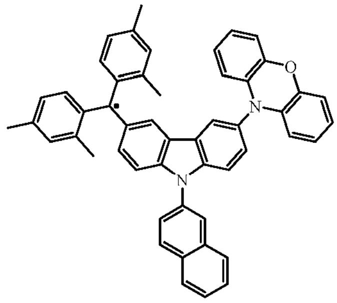

29

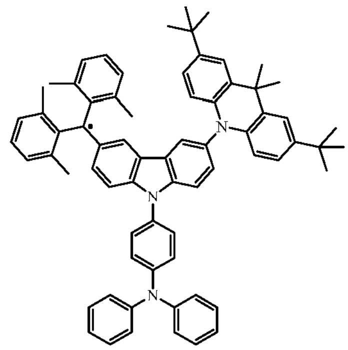

30

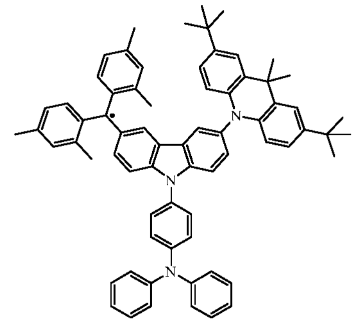

31

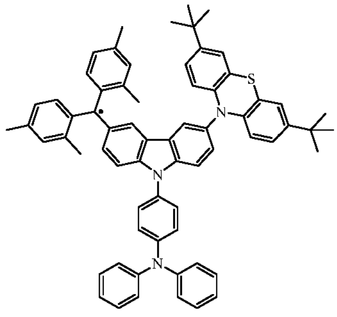

32

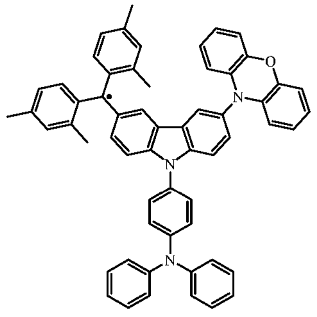

33

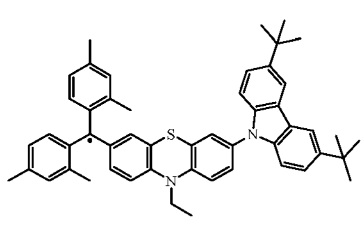

34

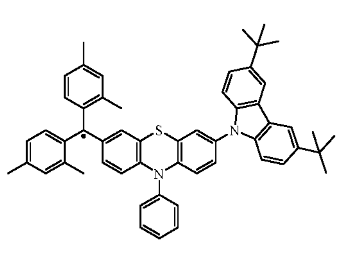

35

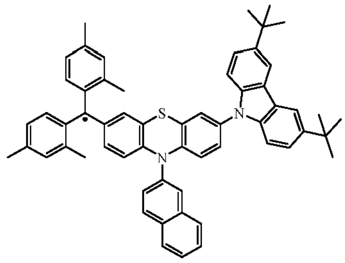

36

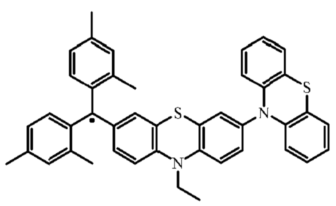

37

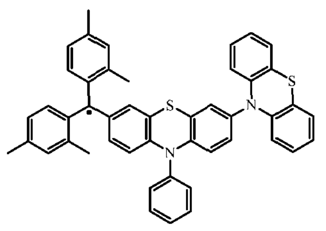

38

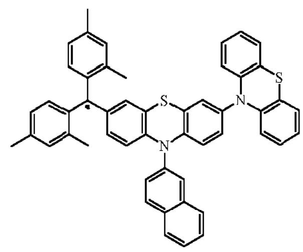

39

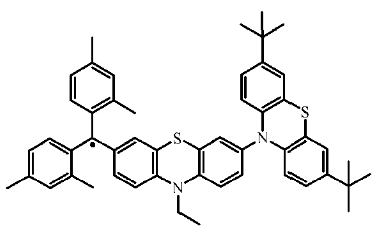

40

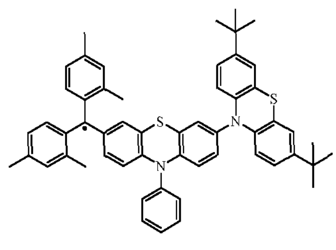

41

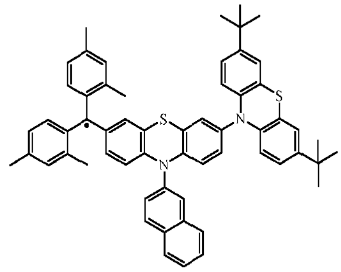

42

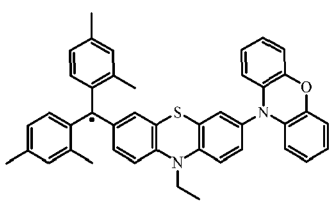

43

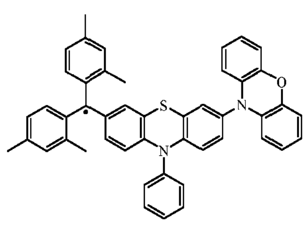

44

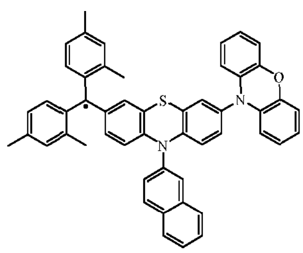

45

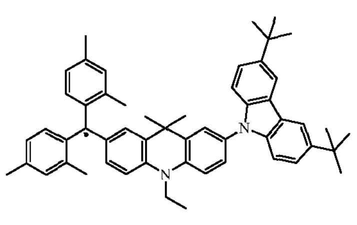

46

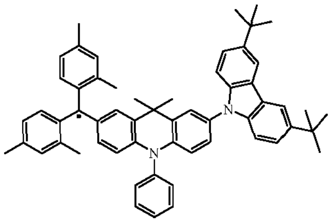

47

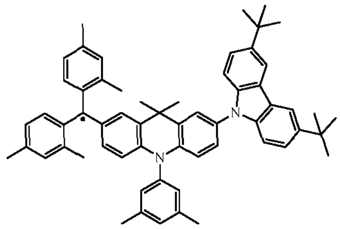

48

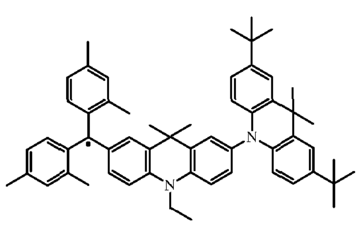

49

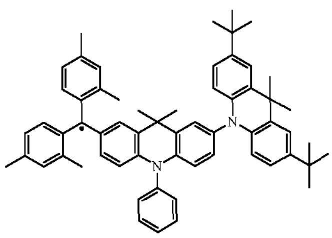

50

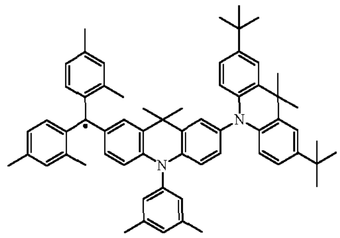

51

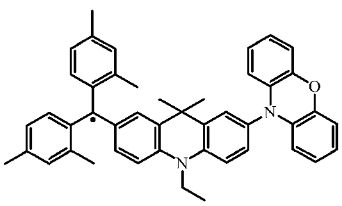

52

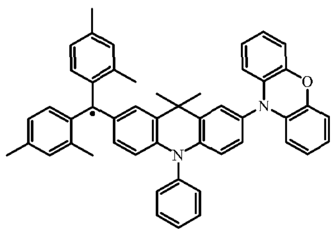

53

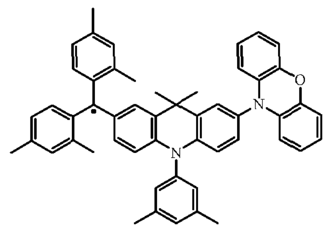

54

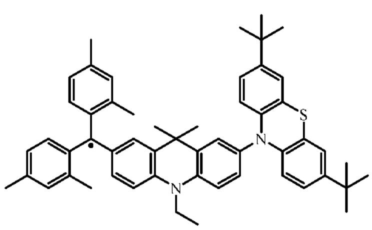

55

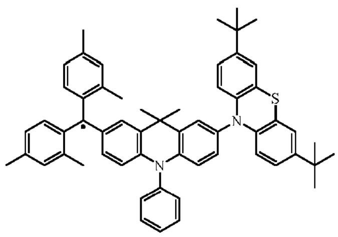

56

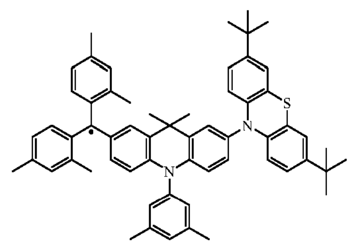

57

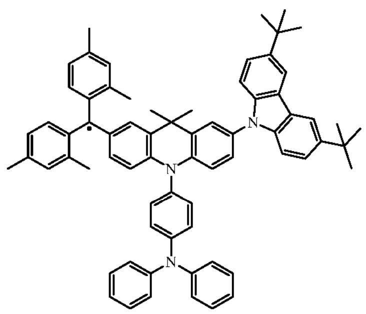

58

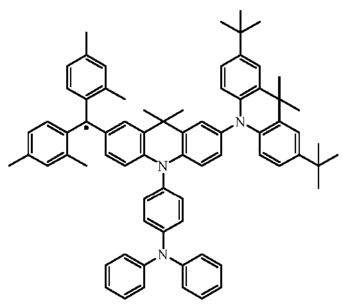

59

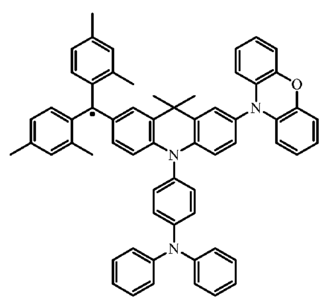

60

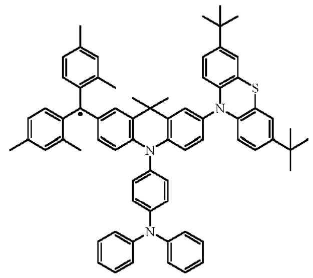

61

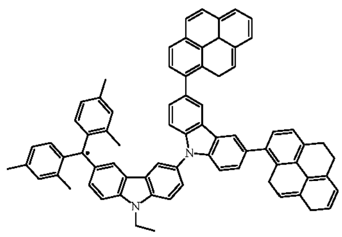

62

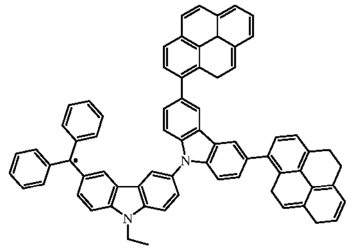

63

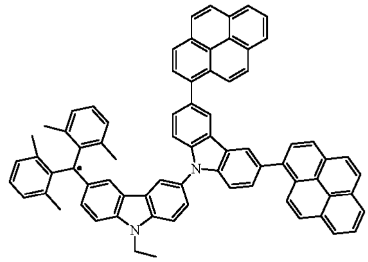

64

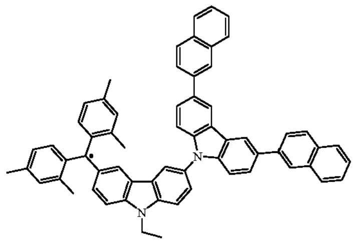

65

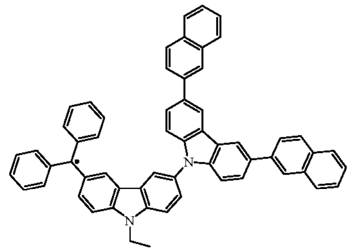

66

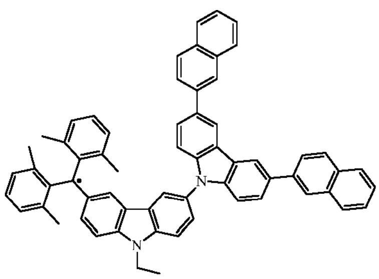

67

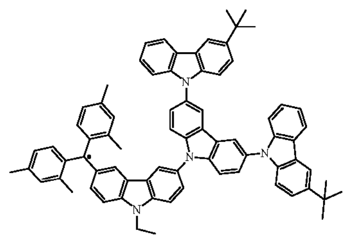

68

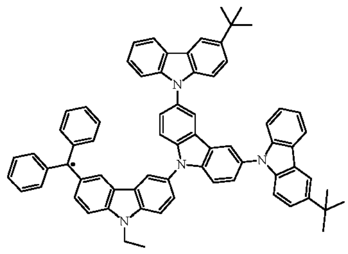

69

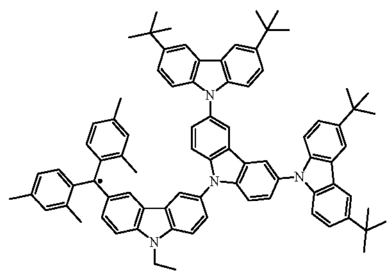

70

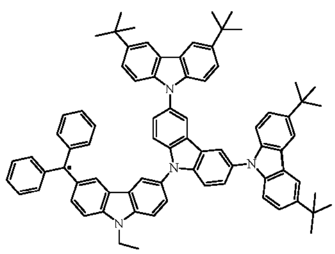

71

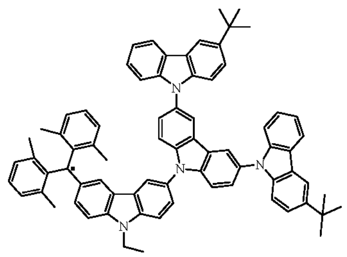

72

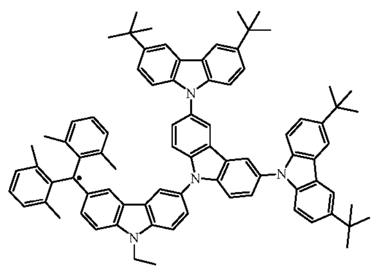

73

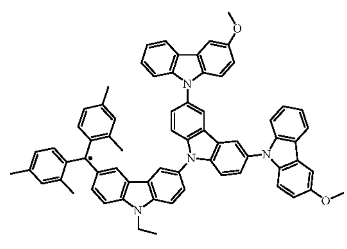

74

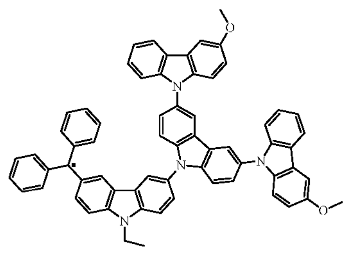

75

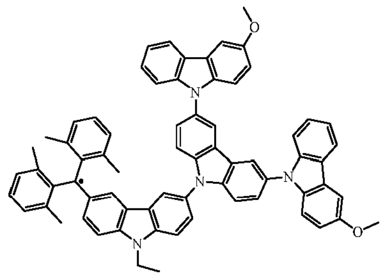
76

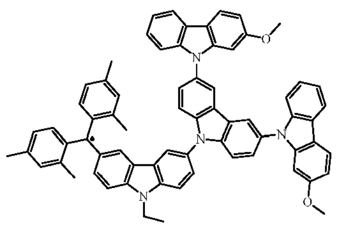
77

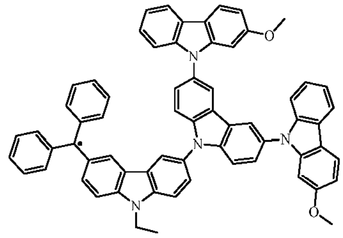
78

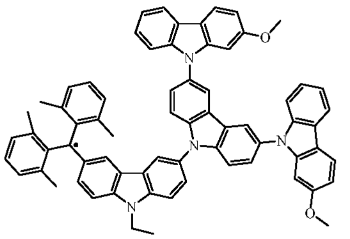
79

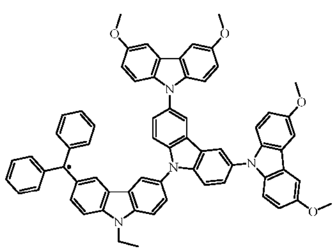
80

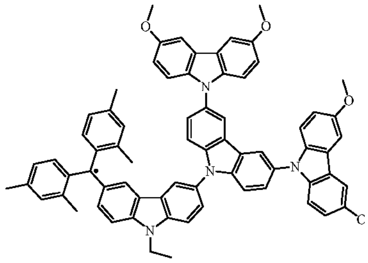
81

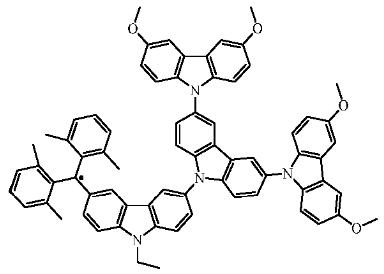
82

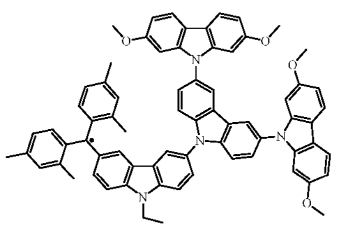
83

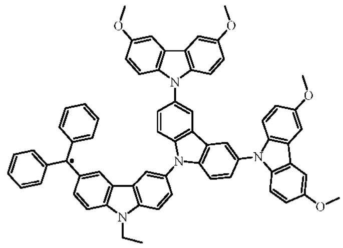
84

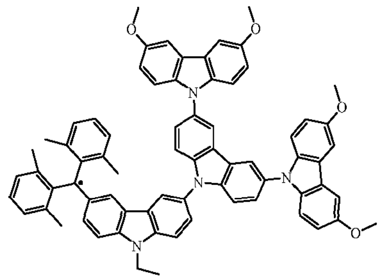
85

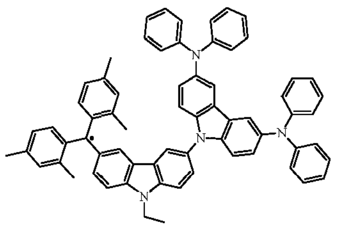
86

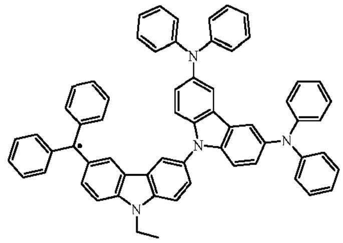
87

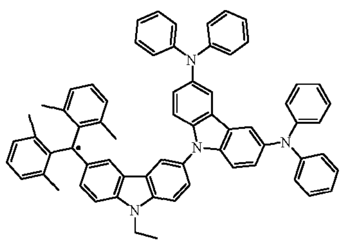
88

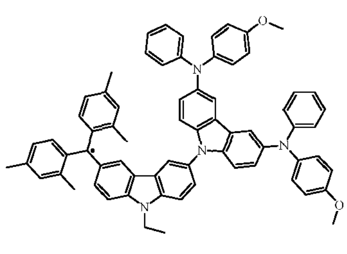
89

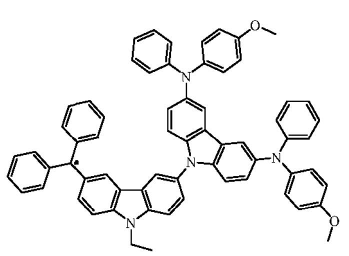
90

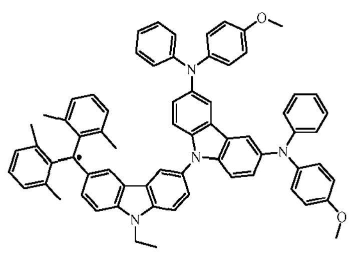

91

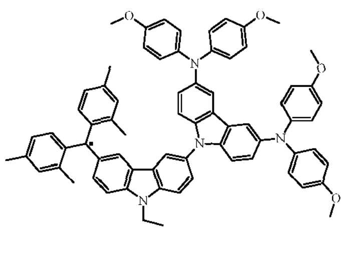

92

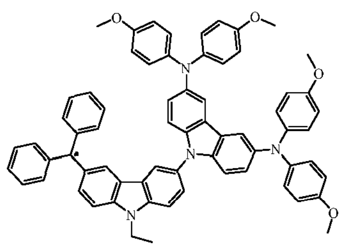

93

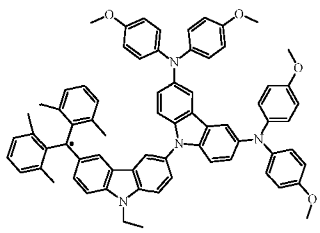

94

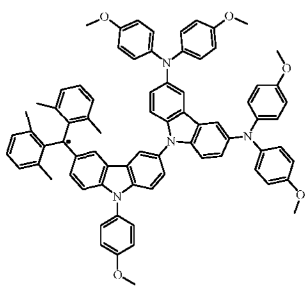

95

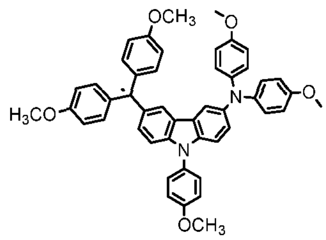

96

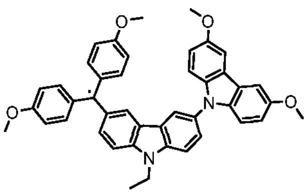

97

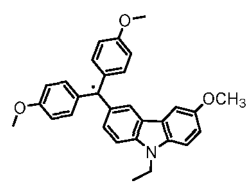

98

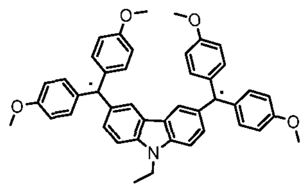

99

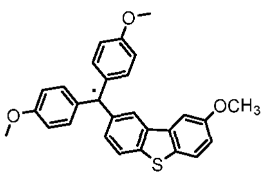

100

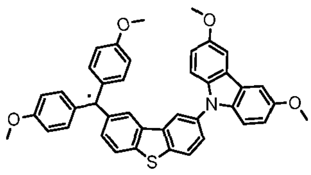

101

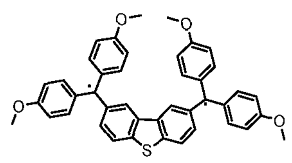

102

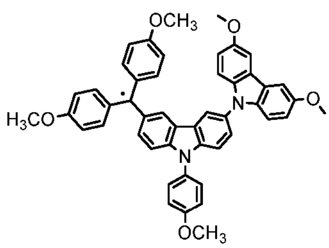

103

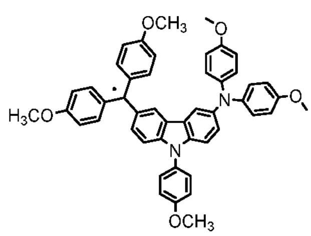

104

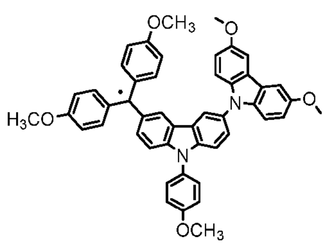

105

**Examples (preferred embodiments).** Information on examples of real embodiments is provided below, describing the modes of synthesis of compounds (1-6) of the present invention and their properties. This information is provided for the illustrative purpose and is not limiting the scope of the present invention.

**Synthesis description of compounds 1-6.** Under argon atmosphere and in the dark, the corresponding intermediate compounds 1-6 (1.00 eqv) are dissolved in dry THF (40 ml) (Figure 1). Then KOtBu (2.00 eqv) is added, the solution become claret coloured immediately. The solution is stirred for 1.5 hours in the dark at room temperature, and then p-chloranil (2.7 eqv.) is added. The solution was stirred for further 1.5 hours. When the reaction finished, its mixture is filtrated through 2-cm layer of Celite® and washed with ethyl acetate. All the volatiles are removed under vacuum and the products are recrystallized from methanol. The electron paramagnetic resonance (EPR) method is used to confirm the radical form (Figure 1). This technique includes the measurement of the energy absorption generated under microwave

irradiation and varying the magnetic field by employing Bruker, Elexsys 560 EPR spectroscopy system. EPR spectroscopy results confirmed the existence of the unpaired electron in molecular structure of all the target compounds with g value variating from 2.00359 to 2.00546 (g=2.0023 for free electron theoretically; Angew. Chem. Int. Ed. 2018, 57, 2869 -2873).

**Example 1.** *6-(Bis(2,4-dimethylphenyl)methyl)-3;6'-di-tert-butyl-9-ethyl-9H-3,9'-bicarbazole radical (compound 1, Scheme 1)*

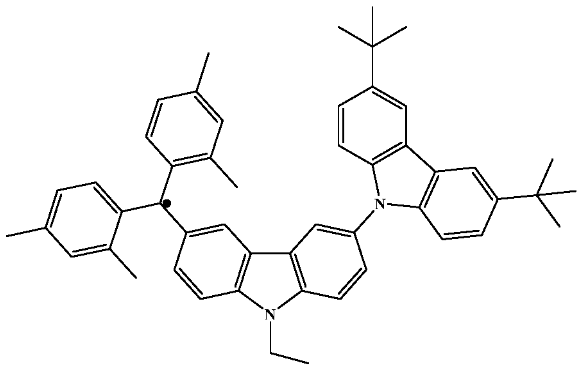

Yield of pale yellow powder is of 28% (0.063 g).

IR vmax (KBr tablet): 3007 (-C-H Ar); 2961, 2946, 2940 (-C-H aliph.); 1491, 1487, 1479 (-C-N-); 1388, 1385, 1374 ((CH3)3C-); 1326, 1316, 1309 (CH3-).

**Example 2.** *6-Benzhydryl-3;6'-di-tert-butyl-9-ethyl-9H-3,9'-bicarbazole radical (compound 2, in Scheme 1)*

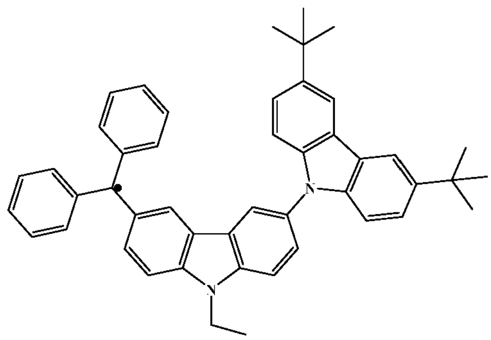

Yield of dark brown powder is of 19% (0.096 g).

IR $v_{max}$ (KBr tablet): 3020 (-C-H Ar), 2987, 2983 (-C-H aliph.); 1490, 1483, 1475 (-C-N-); 1393, 1390, 1387 ((CH3)3C-); 1366, 1362, 1358 (CH3-).

**Example 3.** *6-(Bis(2,6-dimethylphenyl)methyl)-3',6'-di-tert-butyl-9-ethyl-9H-3,9'-bicarbazole radical (compound* ***3,*** *in Scheme 1)*

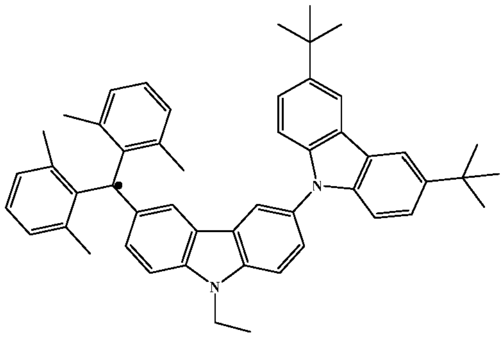

Yield of purple powder is of 13% (0.047 g).

IR vmax (KBr tablet): 3006 (-C-H Ar), 2970, 2968, 2962 (-C-H aliph.); 1483, 1472, 1468 (-C-N-); 1378, 1372, 1370 ((CH3)3C-); 1426, 1418, 1410 (CH3-).

**Example 4.** *10-(6-(Bis(2,4-dimethylphenyl)methyl)-9-ethyl-9H-carbazol-3-yl)-2,7-di-tert-butyl-9,9-dimethyl-9, 10-dihydroacridine radical (compound **4,** in Scheme 1)*

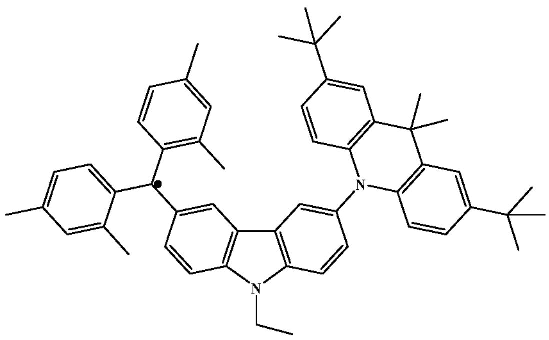

Yield of pale yellow powder is of 24% (0.080 g).

IR vmax (KBr tablet): 3015 (-C-H Ar), 2959, 2951 (-C-H aliph.); 1450, 1447, 1440 (-C-N-); 1392, 1342 ((CH3)3C-); 1387, 1366 (CH3-).

**Example 5.** *10-(6-Benzhydryl-9-ethyl-9H-carbazol-3-yl)-2,7-di-tert-butyl-9,9-dimethyl-9,10-dihydroacridine radical (compound **5,** in Scheme 1)*

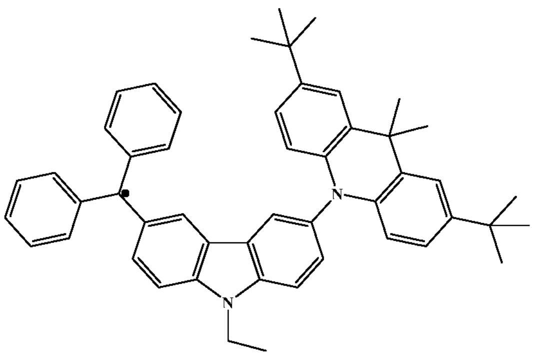

Yield of pale yellow powder was 30% (0.105 g).

IR vmax (KBr tablet): 3025 (-C-H Ar), 2973, 2971, 2965 (-C-H aliph.); 1447, 1440, 1433 (-C-N-); 1315, 1309, 1297 ((CH3)3C-); 1336, 1331, 1328 (CH3-).

**Example 6.** *10-(6-(Bis(2,6-dimethylphenyl)methyl)-9-ethyl-9H-carbazol-3-yl)-2,7-di-tert-butyl-9,9-dimethyl-9,10-dihydroacridine radical (compound* ***6,*** *in Scheme 1)*

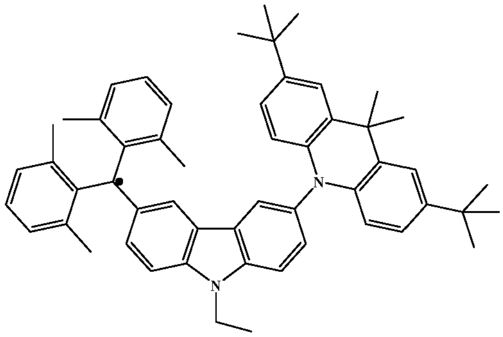

Yield of dark yellow powder is of 17% (0.035 g).
IR vmax (KBr tablet): 3006 (-C-H Ar), 2961, 2958, 2955 (-C-H aliph.); 1463, 1460, 1446 (-C-N-); 1352, 1348, 1337 ((CH3)3C-); 1377, 1374, 1361 (CH3-).

**Example 7.** *Thermal properties*

Differential scanning calorimetry (DSC) measurements are performed using PerkinElmer DSC 8500 equipment at heating and cooling rates of 10 °C/min in a nitrogen atmosphere. Thermogravimetric analysis (TGA) is done using PerkinElmer TGA 4000 apparatus at a heating rate of 20 °C/min in a nitrogen atmosphere. The results of the thermal characterizations of compounds **1-6** are collected in Table 1.
The invented compounds **1-6** are characterized by high thermal stability. Their temperatures of 10% weight loss (Td-10%,) exceed 320°C (Table 1). The compounds for glasses. Their glass-transition temperatures (Tg) are higher than 100 °C displaying the morphological stability of their glasses.

**Table 1.** Thermal characteristics of radicals **1-6.**

| **Compound** | **1** | **2** | **3** | **4** | **5** | **6** |
|---|---|---|---|---|---|---|
| $T_G$, °C | 127 | 117 | 90 | 83 | 105 | 100 |
| $T_{D-10\%}$, °C | 385 | 355 | 318 | 393 | 384 | 320 |

**Example 8.** *Electrochemical and photoelectrical properties*

The cyclic voltammetry (CV) measurements are performed using dry dichloromethane (DCM) as a solvent and tetra-n-butylammonium hexafluorophosphate (Bu4NPF6) as a supporting electrolyte. The reference silver electrode is calibrated by the ferrocene/ferrocenium (Fc/Fc+) redox couple. Platinum was used as a working electrode. The obtained ionization potential ($IP^{CV}$), electron affinity ($EA^{CV}$), and energy gap ($E_G{}^{CV}$) values are presented in Table 2.
$IP^{CV}$ and electron affinity values are estimated using the ferrocene standard potential. $IP^{CV}$ values of the stable radicals depend on the electron-donating nature of dimethylacridan and carbazole moieties attached at the carbazole core. Dimethylacridan-based radicals **4-6** have lower $IP^{CV}$ values indicating better electron donating abilities. Whereas $EA^{CV}$ are very close indicating the influence of radical acceptor. Organic semiconductors with $EA^{CV}$ values higher than 4.0 eV are highly desirable as air-stable electron-transporting materials since they exhibit facilitated charge injection (Adv. Mater. 2013, 25, 5372-5391.).
Ionization potentials ($IP^{PE}$) of the solid films of the radicals (1-6) were additionally recorded by the method of photoelectron emission (PE) spectroscopy in air. The $IP^{PE}$ values of the films were in the range of 3.35-5.76 eV (Table 2). The $IP^{PE}$ values of **1-6** are in good agreement with the corresponding $IP^{CV}$ values, while the differences are caused by the different physical processes taking place in liquid and solid media. $IP^{PE}$ values of **1-6** allow to forecast good hole-injecting properties for their films. This claim was cfonfirmed by electroluminescent experiments when radical **2** was used as the

hole-transporting material in TADF-based OLEDs (see example 11). Moreover, good electron injecting properties are expected for radicals **1-6** due to the relatively high electron affinity ($EA^{PE}$) values. The $EA^{PE}$ values with acceptable errors can be calculated by the formula $EA^{PE}= IP^{PE}-E_G^{opt}$ taking the optical band gaps ($E_G^{opt}$) from the absorption spectra of the films (Mater. Horiz., 2014, 1, 17-19). For example, $EA^{PE}$ value of 4.03 eV was obtained for compound **6** using $E_G^{opt}$ of 1.38 eV (Figure 2).

**Table 2.** Electrochemical characteristics of stable radicals **1-6.**

| Compound | $IP^{CV}$, eV | $EA^{CV}$, eV | $E_G^{CV}$, eV | $IP^{PE}$, eV |
|---|---|---|---|---|
| **1** | 5.45 | 4.43 | 1.02 | 5.76 |
| **2** | 5.45 | 3.19 | 2.26 | 5.35 |
| **3** | 5.62 | 4.47 | 1.15 | 5.76 |
| **4** | 5.19 | 4.28 | 0.91 | 5.40 |
| **5** | 5.25 | 4.38 | 0.87 | 5.35 |
| **6** | 5.29 | 4.40 | 0.89 | 5.41 |

**Example 9.** *Photophysical properties*

UV-vis spectra of the films of radicals **1-6** are recorded on a spectrometer Avantes AvaSpec-2048XL (Figure 3). Photoluminescence (PL) spectra were recorded on a FLS980 fluorescence spectrometer. The peak wavelengths of absorption ($\lambda_{abs}$) and emission ($\lambda_{PL}$) spectra of stable radicals **1-6** are collected in Table 3.

**Table 3.** Photophysical characteristics of thin films of stable radicals **1-6.**

| Compound | 1 | 2 | 3 | 4 | 5 | 6 |
|---|---|---|---|---|---|---|
| $\lambda_{abs}$, nm | 291, 333, 402 | 291, 335, 439 | 289, 304, 338, 406 | 278, 293, 354 | 289, 313, 371 | 278, 334 |
| $\lambda_{PL}$, nm | 365, 380 | 412, 429* | 380, 397 | 408, 427 | 413, 431 | 408 |
| PLQY of aerated toluene solution, % | 17.4 | 20.26 | 12.4 | 8.25 | 6.8 | 3 |
| PLQY of deoxygenated toluene solution, % | 27.8 | 30.76 | 18.46 | 14.6 | 11.5 | 7.25 |
| CIE 1931, (x, y) | (0.16, 0.06) | (0.18, 0.05) | (0.16, 0.02) | (0.16, 0.04) | (0.16, 0.04) | (0.16, 0.04) |
| * Shoulder. | | | | | | |

The absorption bands located between 289-360 nm correspond to the overlapping of absorption bands the electron-donating moieties of **1-6.** For example, two absorption bands at ca. 289-291 and ca. 333-355 nm are products of $\pi$-$\pi$* and n-$\pi$* electronic transitions (also described as $^1L_b$ (S1-S0) and $^1L_a$ (S2-S0) electronic transitions) of the molecular backbone of carbazole, respectively (J. Lumin. 2002, 97, 83-10192). Similarly, dimethylacridan moiety is characterized by an abpsortion band peaking at ca. 290 nm (Org. Electron., 2019, 70, 227-239). Low-energy bands/tails at the wavelengths longer than 360 nm are attributed to the charge transfer (CT) between electron-donating moieties and acceptor radical fragments. Those low-energy bands/tails are very weak apparently because of the low oscillator strengths. They even were not well recognized for thin films but well seen for thick films (Figure 3a). The edges of absorption spectra of radicals **1-6** were observed in the infrared region suggesting the narrow energy gaps. These observations correlate well with the results of CV or PE measurements (Table 2).

Because of the low oscillator strength of CT electronic transitions, the emission of dilute toluene solutions of radicals **1-6** is in violet - blue region (Figure 3b). The emissions of toluene solutions of **1-6** are sensitive to the presence of oxygen. Their emission quantum yields increased after deoxygenation (Table 3). Their emission colours correspond to CIE 1931 colour coordinates which are close to the National Television System Committee (NTSC) blue colour standard of (0.14, 0.08) (Table 3) (Org. Electron. 2009, 10, 158-162). The emission of solid films of radicals **1-6** is also in violet - blue region. It is different from that of other reported radicals emitting in red region emission of which resulted from the relaxation of the lowest excited doublet state ($D_1$) (J. Org. Chem. 2014, 79, 1771-1777). Photoexcitation of doublet-ground-state ($D_0$)

molecules generates doublet excited states, and spin-allowed emission, i.e, doublet emissions in these molecules originate from the lowest-lying doublet excited state (Nature, 2018, 563, 536-540). The shape of the emission band is similar to that of carbazole local excitation. Thus, in the case of radicals **1-6,** the generated doublets may relax towards the LE state of carbazole and emit from the latter. However, the emission spectra of radicals **1-6** are redshifted in comparison to the fluorescence of carbazole local excitation peaking at 341 and 356 nm (J. Lumin. 2002, 97, 83-10192). The emission spectrum of the toluene solution of 2 is red-shifted in comparison to the spectrum of its precursor (Figure 3c). Therefore, the emission of **1-6** is rather like anti-Kasha emission of carbon-centred radicals which demonstrate doublet emission from the upper doublet states ($D_n$) (Nat. Commun. 2022, 13, 5367). Taking into account that the edges of absorption spectra of radicals **1-6** are in the infrared region, their lowest doublet states should also be in the infrared region. Thus, compounds **1-6** show anti-Kasha emissions possibly resulting from emissive relaxation of upper doublet states. If so, compounds **1-6** demonstrate the most blue-shifted doublet emission so far published in open-access literature. The CIE 1931 colour coordinates of **3** are of (0.16, 0.02) (Table 3).

The doublet-spin nature of the radical emitters is advantageous for applications in organic light-emitting diodes, as it avoids the formation of triplet excitons that limit the electroluminescence efficiency of non-radical emitters (Nature Materials, 2020, 19, 1224-1229). The short emission lifetime suggests that radiative decay occurs by fluorescence that can boost device efficiency when used in the active layers of OLEDs. To prove this prediction, the photostability test for compounds **1-6** was carried out by the similar procedure as it was previously reported for doublet emitters (J. Am. Chem. Soc. 2020, 142, 38-43). Despite of the selection of rather drastic UV conditions (UV irradiation intensity of 1.1 $mW/cm^2$ at the excitation wavelength of 365 nm), the emission intensity (I) of the toluene solution of compound **1** was little changed during irradiation time of 20 min in comparison to the emission intensity recorded before irradiation ($I_0$) (Figure 3d and 3e). The rise of emission intensities of toluene solutions of compounds **4** and **6** was observed due to their emission sensitivity to active oxygen which is deactivated under UV excitation (Figure 3e, Table 3). Thus, relatively stable blue doublet emitters can be obtained using the stable radical acceptor and appropriate (stable and UV emitting) donor units.

**Example 10.** *Charge-transporting properties*

Charge-transporting properties of the layers of stable radicals **1-6,** are studied by time of flight (TOF) (Figure 4). In the setup for the TOF measurements, EKSPLA NL300 laser (excitation wavelength of 355 nm), 6517B electrometer (Keithley), and TDS 3032C oscilloscope (Tektronix) are used. To test the ability to transport holes and electrons of compounds **1-6,** TOF transients under positive and negative polarity of applied electric fields are recorded. When two different slopes (intercepts of which give the transit times ($t_{tr}$)) are obtained from the corresponding TOF transients build in log-log scales, hole and electron mobilities are calculated according to the equation $\mu = d^2/(U \times t_{tr})$ taking transit times $t_{tr}$ from the photocurrent transients at applied voltage (U) and thicknesses of the layers (d) measured by the charge extraction by linearly increasing voltage (CELIV) technique assuming dielectric constant $\varepsilon = 3$ for the studied compounds. The samples for the TOF are fabricated on pre-patterned and pre-cleaned ITO glass substrates with sheet resistance of 15 $\Omega$/sq. The films for the TOF measurements are vacuum deposited with Kurt J. Lesker equipment integrated into glove box.

Bipolar charge transport was observed for vacuum-deposited films of stable radicals **1-4** and **6.** Taking transit times at different applied voltages, hole and electron mobilities were calculated for the compounds. Their dependences on electric field were in good agreement with Poole-Frenkel type mobility predicted by the relationship $\mu = \mu_0 e^{\alpha E^{1/2}}$. The highest and most balanced electron and hole mobilities were observed for the dimethylacridan-based radical **4.** At electric field of $3.5 \cdot 10^5$ V/cm, hole- and electron drift mobilities were found to be of $7.35 \times 10^{-4}$ $cm^2/V \cdot s$ and of $4.51 \times 10^{-4}$ $cm^2/V \cdot s$, respectively. Lower electron mobility values ($2.29 \times 10^{-5}$-$2.33 \times 10^{-4}$ $cm^2/V \cdot s$) were observed for compounds **1, 3** and **6.** Bipolar and well-balanced charge transport was also observed for carbazole-based radical **2.**

Efficient bipolar and electron transport can be attributed to the radical character of trivalent carbon (Chem. Commun., 2010,46, 5130-5132). Oxidation and reduction processes in the radical series **1-6** can be attributed to the capability of the semi-occupied molecular orbital (SOMO)-which presents a major contribution of the localized $\pi$ orbital of the trivalent carbon atom-of losing its single electron or gaining one electron. Thus, the hole- and electron-transport for these materials proceeds through a non-bonding SOMO orbital but not through the HOMO and LUMO orbitals, respectively (Chem. Eur. J. 2016,22,18551-18558). The measured hole and electron mobility values of radical **4** are among the highest ones reported for stable radicals and comparable with those of the widely used tris(2,4,6-trichlorophenyl)methyl (TTM) series of radicals (J Phys Org Chem. 2019;32:e3974).

**Example 11.** *Electroluminescent properties*

Radical **2** as the hole-transporting material was additionally tested in solution-processable OLEDs with device structure ITO/PEDOT:PSS/radical **2**/mCP/mCBP:DACTII/TSPO1/TPBi/LiF:Al. OLEDs were fabricated by the following procedure. PEDOT:PSS (poly(3,4-ethylenedioxythiophene) polystyrene sulfonate) was used for the fabrication of the hole

injection layer. Water-based PEDOT:PSS dispersion Al 4083 from Ossila (80 μl )was dropped on a precleaned patterned glass substrate with indium tin oxide (ITO) and deposited using a SPS Spin 150i spin-coater in an air. The ITO substrate was precleaned by acetone, putting the sample in a KRAFT&DELE PROFESSIONAL KD448 ultrasonic bath for 10 min and by Osilla UV Ozone Cleaner for 5 min. The sequence of spin-coating were 5 s of 100 rpm spin speed followed consecutively by 20 s of 2000 rpm rotation, 10 s of 500 rpm spin and 20 s of 3000 rpm spin. The substrate with the film was heated on a plate for 30 min at the temperature of 110 °C. 1,2-dichlorbenzene solution of SM13 with a concentration of 8 mg/ml (75 μ) of was dropped on a substrate and spin-coated for 80 s using a SPS Spin150 spin-coater in a nitrogen atmosphere. The spin speed was 2000 rpm. Spin acceleration was 1000 rpm/s in both cases of deposition by spin-coating. The substrate with the layers was heated then on a plate for 30 min at the temperature of 50 °C in the nitrogen atmosphere. All the following layers were deposited by a thermal vacuum deposition technique under the ultrahigh vacuum with the pressure of $2\text{-}5\cdot10^{-6}$ mBar using Kurt J. Lesker equipment in-built in a MB EcoVap4G glove box. The rate of deposition of the layers by the method was 1Å/s. 1,3-Bis(N-carbazolyl)benzene (mCP) was used for the fabrication of exciton blocking layer with the thickness of 10 nm. The thickness of the emitting layer of TADF emitter 2,9-[4-(4,6-diphenyl-1,3,5-triazin-2-yl)phenyl]-N3,N3,N6,N6-tetraphenyl-9H-carbazole-3,6-diamine (DACT-II) doped into 3,3'-di(9H-carbazol-9-yl)-1,1'-biphenyl (mCBP) host matrix (7 wt.%) was of 30 nm. Diphenyl[4-(triphenylsilyl)phenyl]phosphine oxide (TSPO1) was employed as an hole blocking material. The respective layer had the thickness of 5 nm. The 50 nm layer of 2,2',2"-(1,3,5-benzinetriyl)-tris(1-phenyl-1-H-benzimidazole) (TPBi) was deposited as an electron transport layer. The electron injection layer of LiF with the thickness of *ca.* 0.4 nm followed by the layer of aluminium as a cathode. Current density-voltage characteristics were measured using a 2400-C Keithley sourcemeter. The current density-luminance characteristics were recorded simultaneously with the current density-voltage correlation via a calibrated silicon photodiode and a 6517B Keithley electrometer. Electroluminescence (EL) spectra were recorded at the different voltages by an Avantes AvaSpec-2048XL spectrometer. The measurements of EL characteristics were done in the air at room temperature without passivation of the sample.

Turn-on voltage (4.3 V) is defined as a voltage at which the brightness reach 0.1 cd/$m^2$. The relatively low value of turn-on voltage mainly is an indication of an appropriate charge balance. The EL spectra of the fabricated OLED has a single Gaussian-shaped peak at 500 nm showing no changes of a position with applying higher voltages. The EL spectra of OLED represent the signature emission of DACT-II to a great extent (Nat. Commun. 2015, 6, 8476). The maximum values of current and power efficiency were of 47.1 cd/A and 23.3 lm/W, respectively. The maximum external quantum efficiency (EQE) was of 16.9%. EQE was characterized by roll-off of 6% from the maximum value at 1000 cd/$m^2$ and 46% at 5000 cd/$m^2$. It was caused by the degradation of the organic layers and by intensification of triplet-related effects such as triplet-polaron quenching and triplet-triplet annihilation. OLED showed the maximum brightness of 15.8 thousand cd/$m^2$. Good, as for DACT-II-based TADF devices, output parameters of the fabricated OLEDs with the spin-coated hole-transporting layer on radical **2** additionally prove its good hole-injecting and hole-transporting properties. Radical **2** can be selected as electroactive material for the development of many other electronic devices.

## Claims

1. An organic bipolar semiconductor of donor-acceptor-type, selected from the group of compounds:

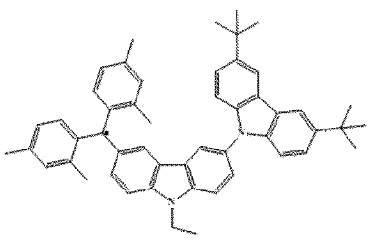

1¶

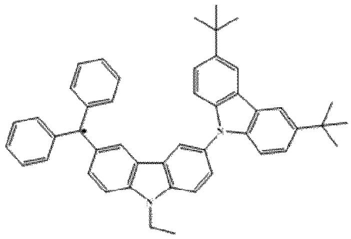

2¶

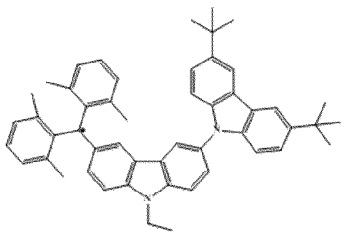

3¶

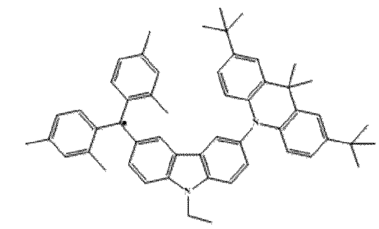

4¶

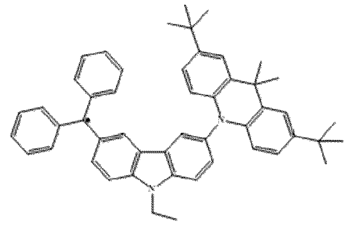

5¶

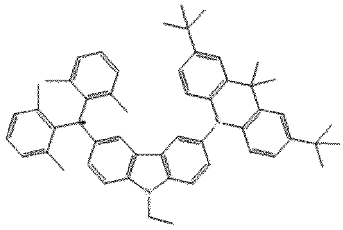

6¶

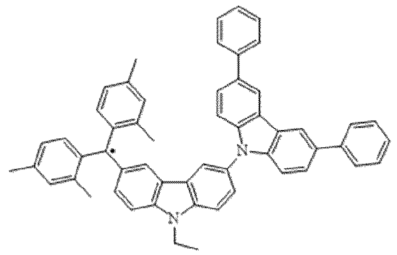

7

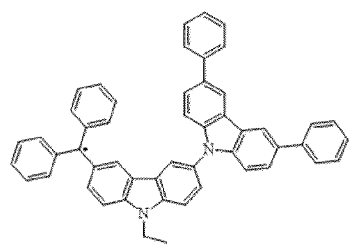

8

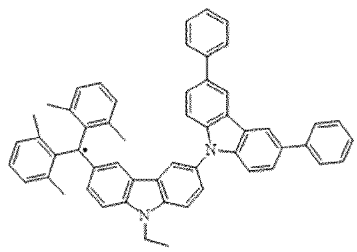

9

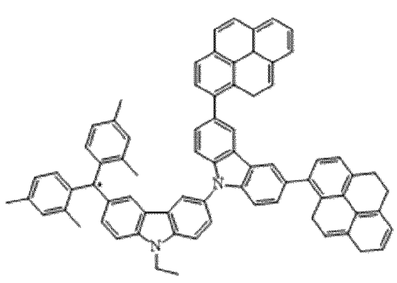

62

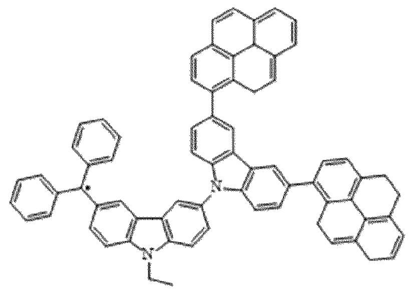

63

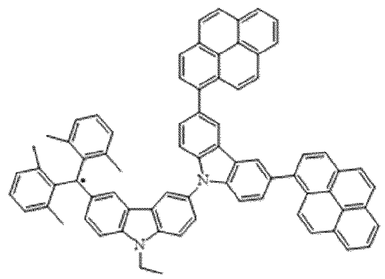

64

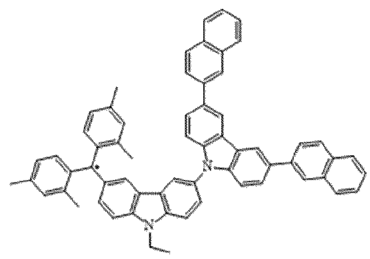

65

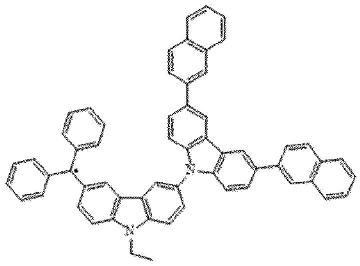

66

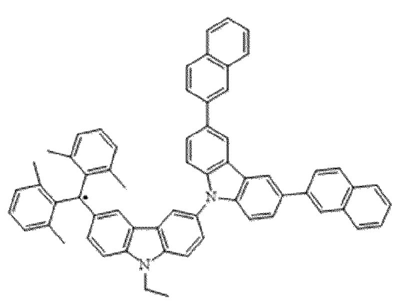

67

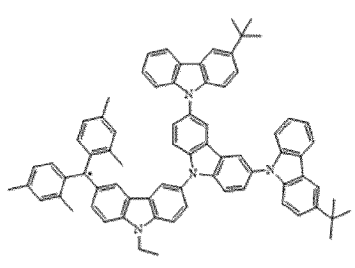

68

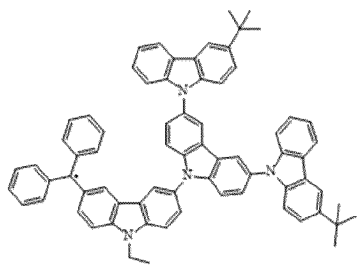

69

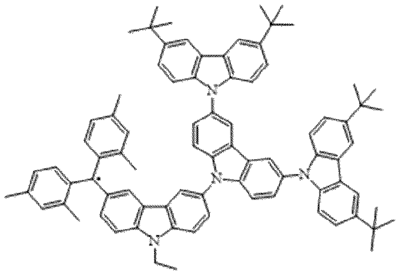

70

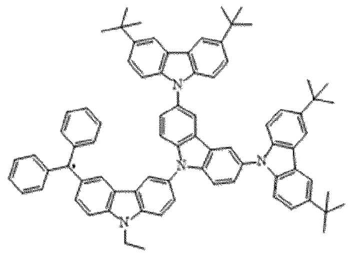

71

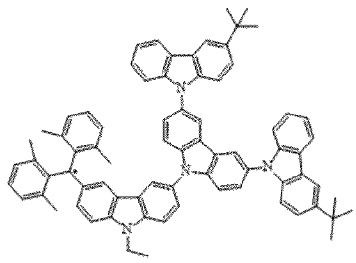

72

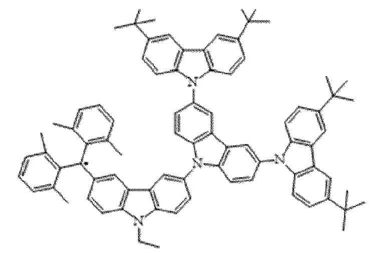

73

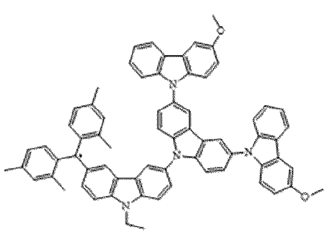

74

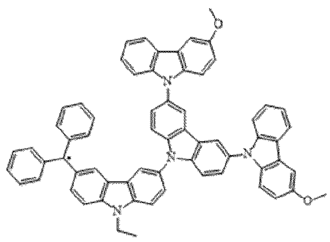

75

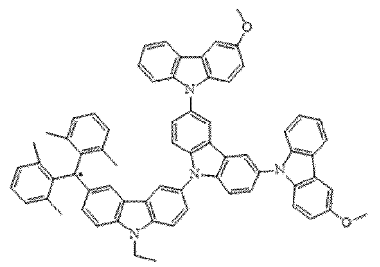

76

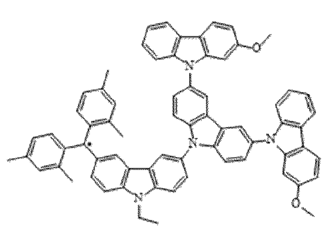

77

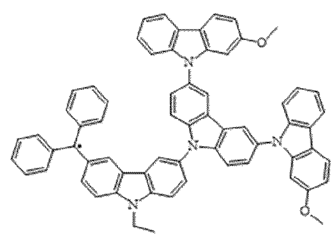

78

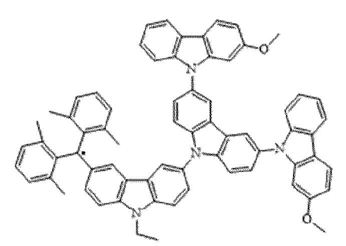

79

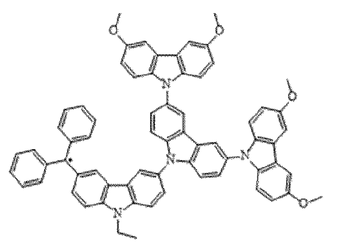

80

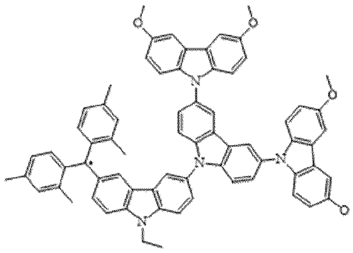

81

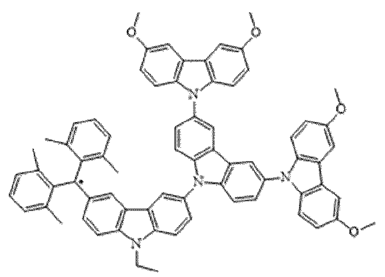

82

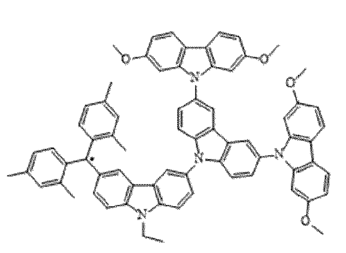

83

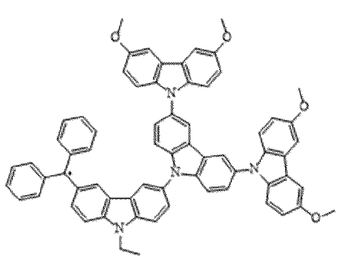

84

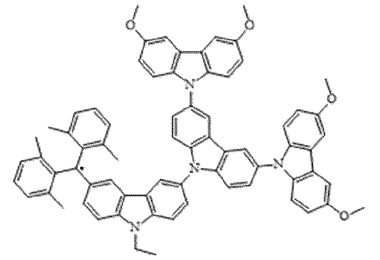

85

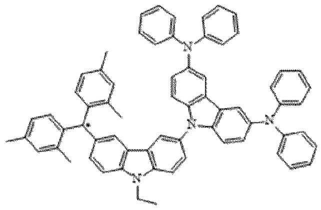

86

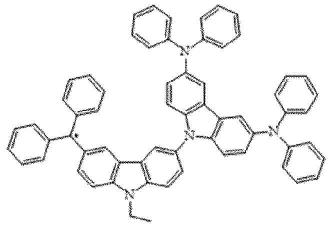

87

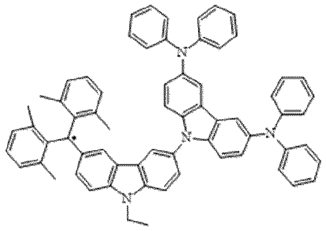

88

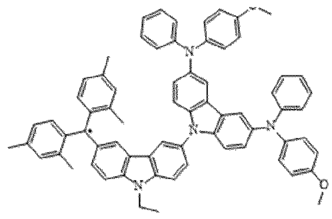

89

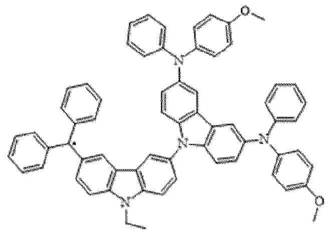

90

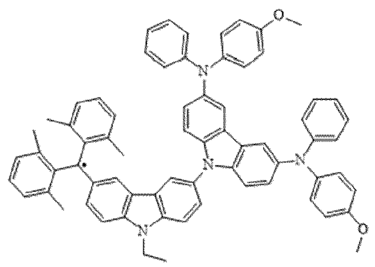

91

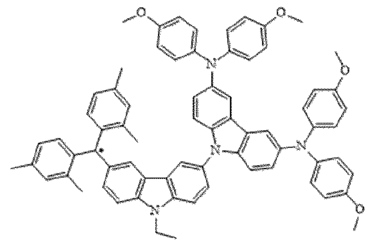

92

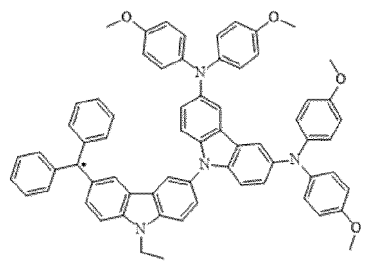

93

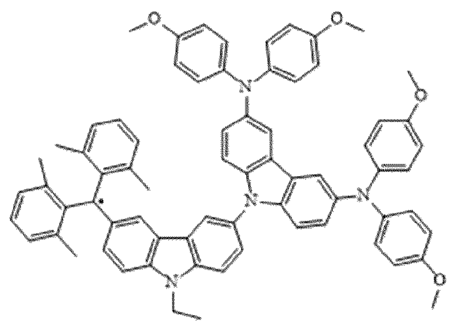

94 .

**2.** The organic semiconductor according to claim 1, **wherein** the radical is selected from the group of compound 1)-6) radicals:

1) 6-(Bis(2,4-dimethylphenyl)methyl)-3',6'-di-tert-butyl-9-ethyl-9H-3,9'-bicarbazole

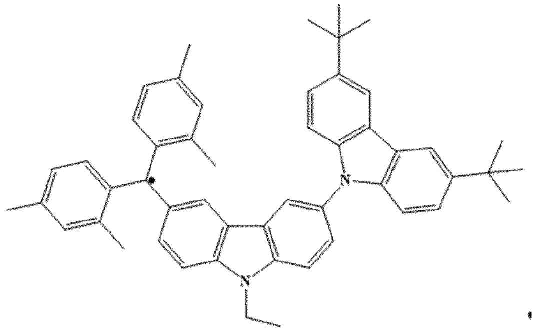

,

2) 6-Benzhydryl-3',6'-di-tert-butyl-9-ethyl-9H-3,9'-bicarbazole

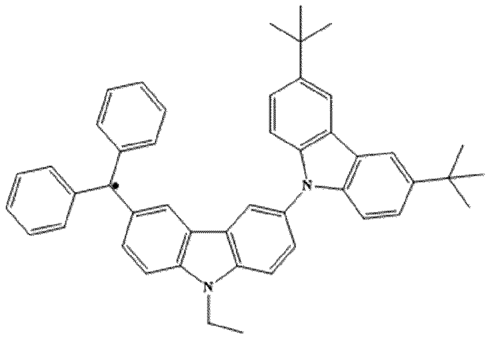

;

3) 6-(Bis(2,6-dimethylphenyl)methyl)-3',6'-di-tert-butyl-9-ethyl-9H-3,9'-bicarbazole

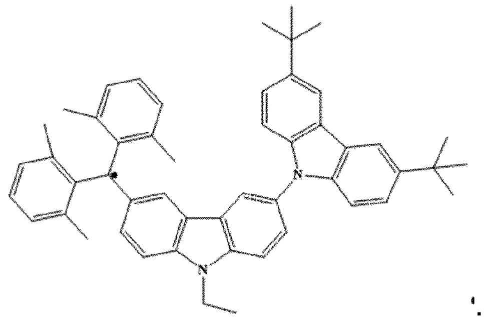

;

4) 10-(6-(Bis(2,4-dimethylphenyl)methyl)-9-ethyl-9H-carbazol-3-yl)-2,7-di-tert-butyl-9,9-dimethyl-9,10-dihydroacridine

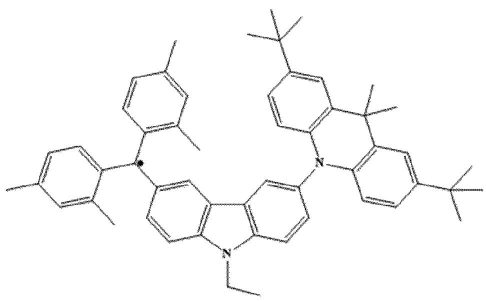

;

5) 10-(6-Benzhydryl-9-ethyl-9H-carbazol-3-yl)-2,7-di-tert-butyl-9,9-dimethyl-9,10-dihydroacridine

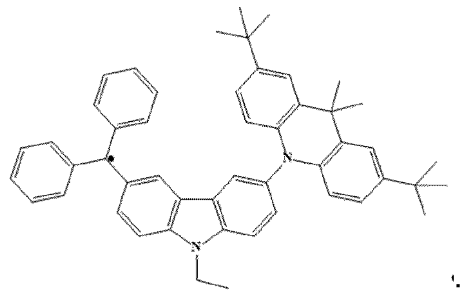

;

6) 10-(6-(Bis(2,6-dimethylphenyl)methyl)-9-ethyl-9H-carbazol-3-yl)-2,7-di-tert-butyl-9,9-dimethyl-9,10-dihydroacridine

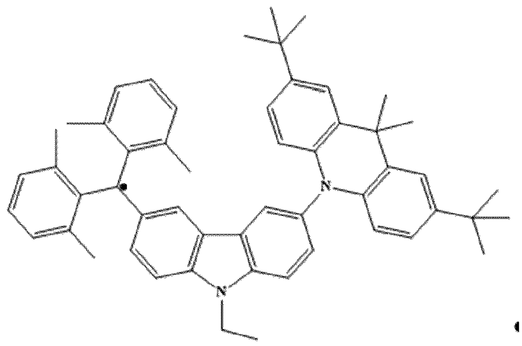

.

3. A method of synthesis of the bipolar organic semiconductor according to any claims of 1 to 2, **wherein** the radical acceptor corresponding to the general formula (I) is synthesised *via* Friedel-Crafts alkylation reaction by at least steps of

**a)** aromatic amine is alkylated by the reaction with aromatic alcohol in the presence of Lewis acid as catalyst, to obtain the alkylated aromatic amine as an intermediate compound;
**b)** the following dehydrogenation of the alkylated aromatic amine is performed by adding *p*-chloranyl, to obtain stable free radical; and
**c)** after the reaction finished, the reaction mixture is filtrated and washed with ethylacetate;
**d)** all the volatiles are removed under vacuum;
e) and the products are recrystallized from methanol.

4. The method of claim 3 of synthesis of the bipolar organic semiconductors **1)-6)** according to claim 3, **comprising** steps of

• in the step **a),** an aromatic amine of the formula

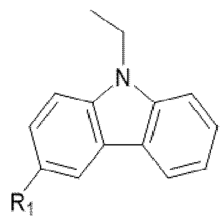

,

wherein $R_1$ is Carbazole for the semiconductors **1),2),3),** and Dimethylacridane for the semiconductors **4),5),6),** is alkylated by the reaction with an aromatic alcohol of the formula

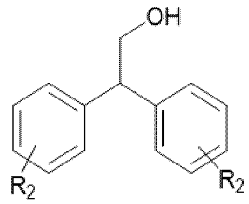

,

wherein $R_2$ is 1,3-dimethyl- for the semiconductors **1),4),** H for the semiconductors **2),5),** and 2,4-dimethyl- for the semiconductors **3),6),** in the presence of Lewis acid as catalyst, to obtain the alkylated aromatic amine as an intermediate compound **I 1-6;** and

• in the step **b),** the dehydrogenation of the alkylated aromatic amine of any said intermediate compound **11-6** is performed, to obtain stable free radical, by the following sub-steps:

◦ Under argon atmosphere and in the dark, the corresponding intermediate compounds **I1-6** of 1.00 eqv are dissolved in dry THF of 40 ml;
◦ KOtBu of 2.00 eqv is added, the solution become claret coloured immediately;
◦ The solution is stirred for 1.5 h in the dark at room temperature, and then p-chloranil of 2.7 eqv. is added;
◦ The solution was stirred for further 1.5 h, until the reaction is finished.

**5.** The method of any claim of 3 to 4, further **comprising**

• using the electron paramagnetic resonance method to confirm the radical form wherein the measurement of the energy absorption generated under microwave irradiation and varying the magnetic field by employing a spectroscopy system.

**6.** An organic light-emission device (OLED) comprising a donor-acceptor structure **wherein** said donor-acceptor structure comprises the organic semiconductor according to any of claims 1 to 2.

**7.** Use of the organic semiconductor according to claims 1-2 as electroactive materials in optoelectronic devices.

**8.** The use according to claim 7 wherein the bipolar organic semiconductor is any of emitters, hosts, charge-transporting, charge-injecting, charge-blocking, or exciton-blocking materials in an organic light-emitting diode.

**9.** The use according to claim 7 as material in light-emitting diodes based on perovskites; the LED consisting essentially of an indium-tin-oxide anode, a layer of PEDOT:PSS as hole-injection layer, and a layer of perovskite-based light-emitting material, an electron transport layer of the claimed compound(s) and a cathode.

**10.** The use according to claim 7 wherein the bipolar organic semiconductor is an absorber and/or charge transporting material in organic and/or hybrid photo detectors and solar cells.

**11.** The use according to claim 7 wherein the bipolar organic semiconductor is a functional material of vertically configured organic light-emitting transistors (VOLETs).

**12.** The use according to claim 7 in optical chemo-sensors.

**13.** The use according to claim 7 wherein the bipolar organic semiconductor is active material in memory devices.

## Patentansprüche

**1.** Organischer bipolarer Halbleiter vom Typ Donator-Akzeptor, der aus der Gruppe der folgenden Verbindungen ausgewählt ist:

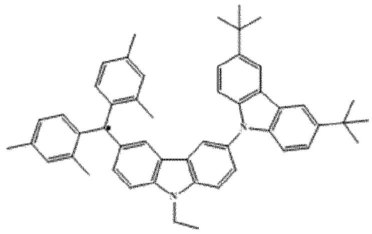

1¶

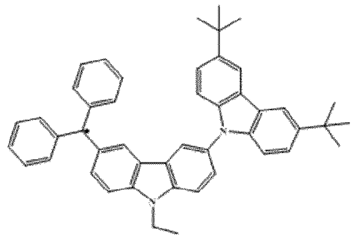

2¶

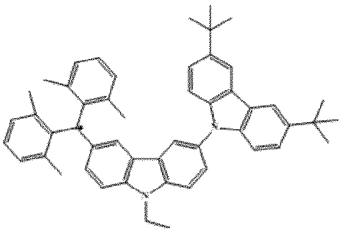

3¶

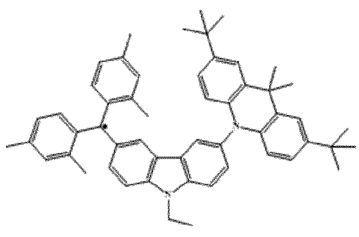

4¶

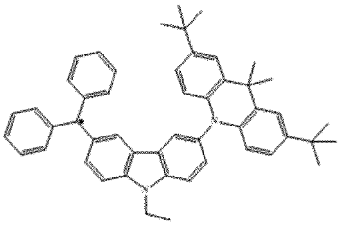

5¶

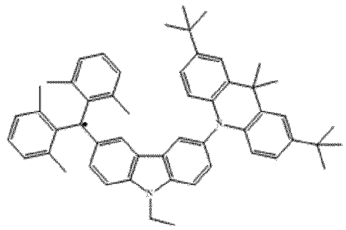

6¶

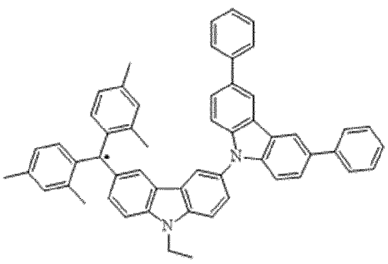

7

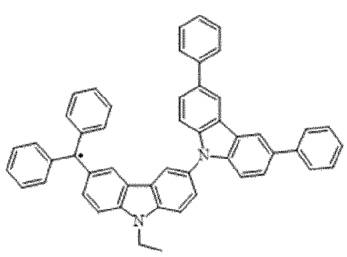

8

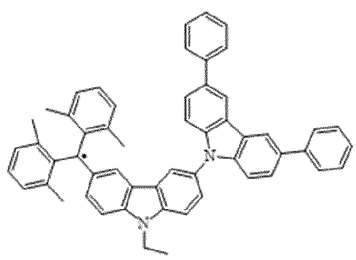

9

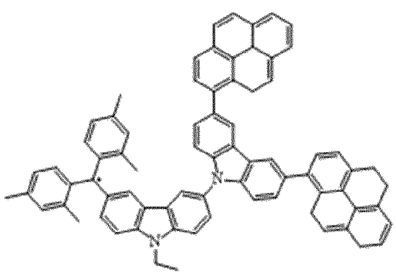

62

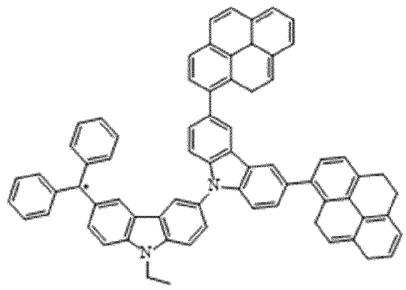

63

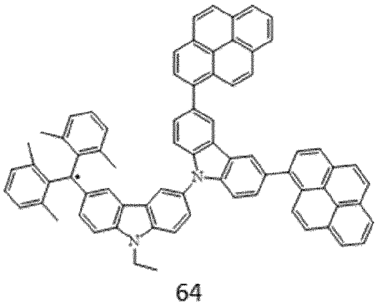

64

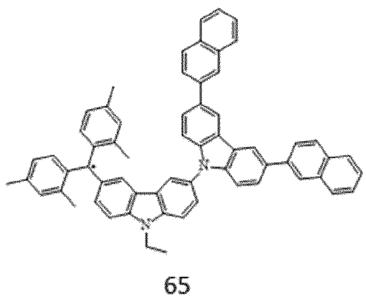

65

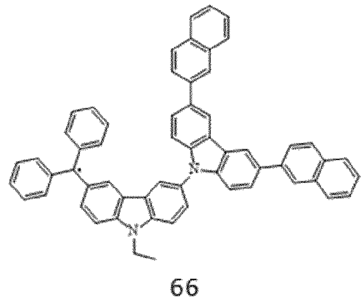

66

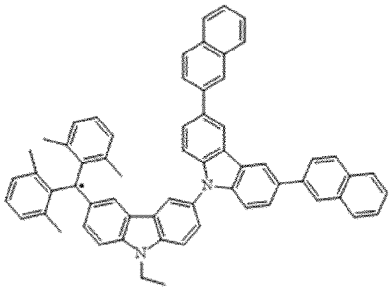
67

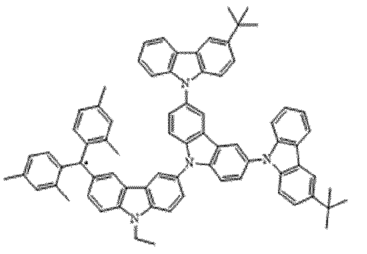
68

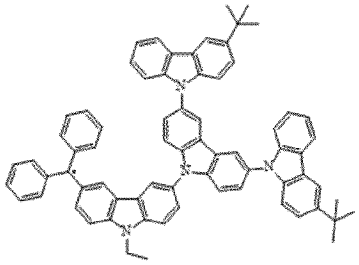
69

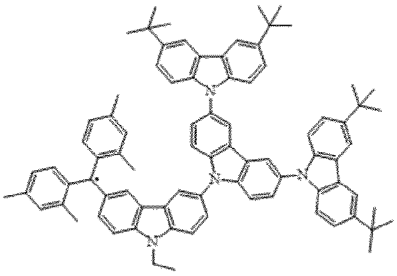
70

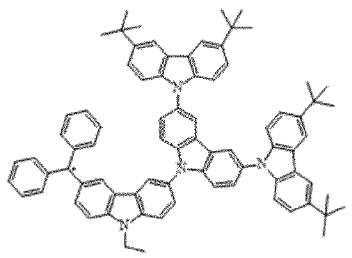
71

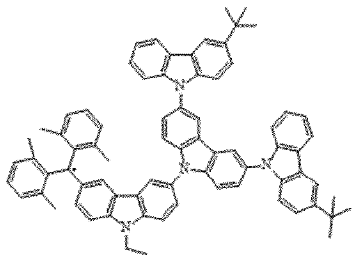
72

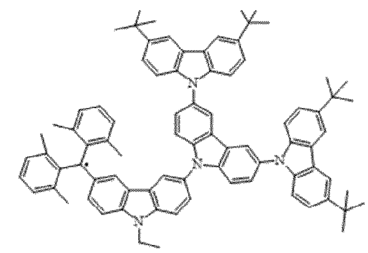
73

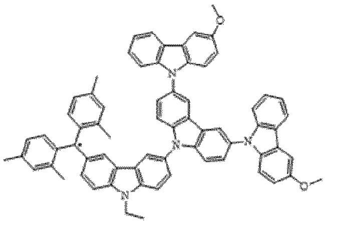
74

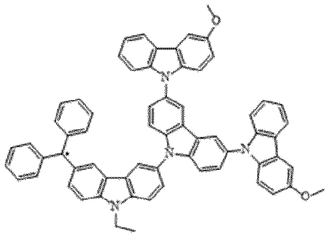
75

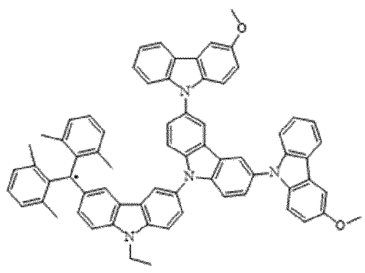
76

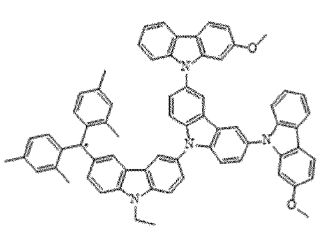
77

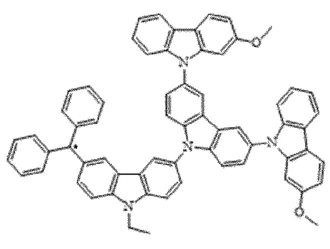
78

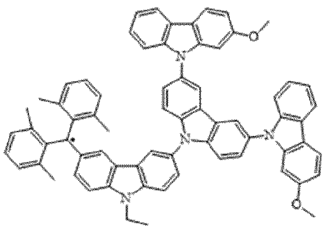
79

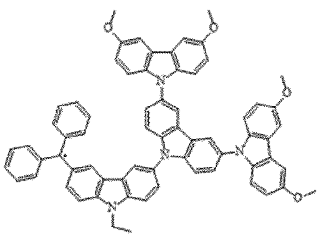
80

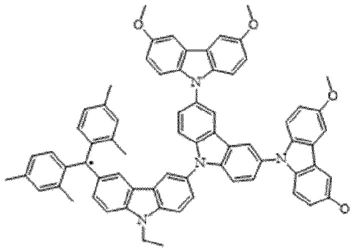
81

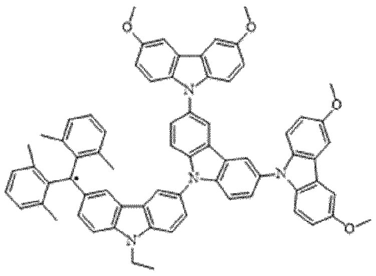
82

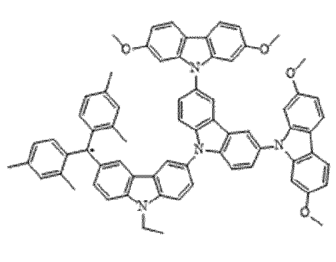
83

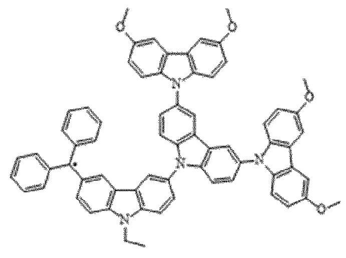
84

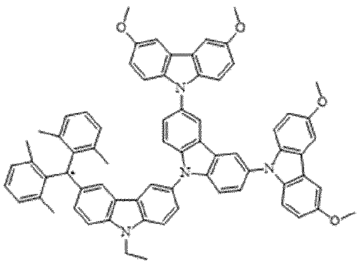
85

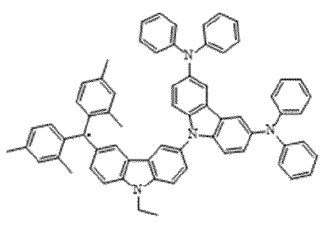
86

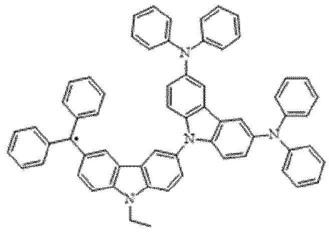
87

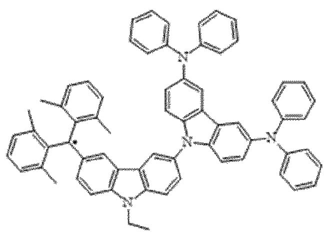
88

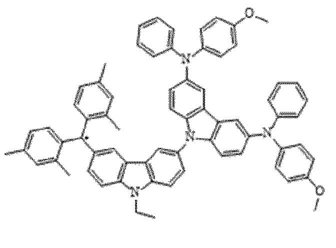
89

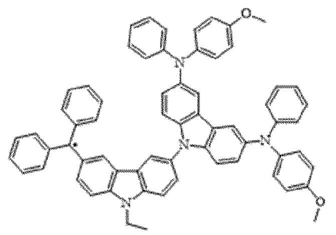
90

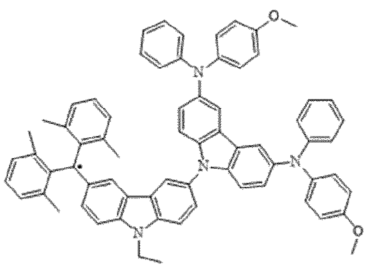
91

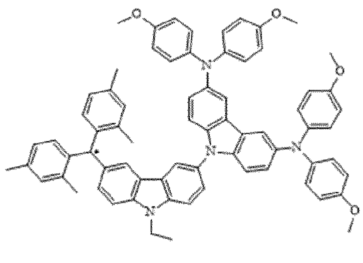
92

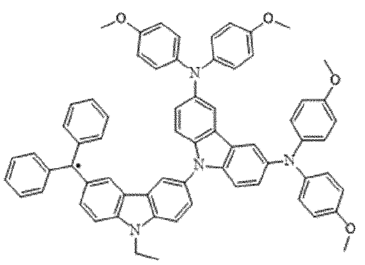
93

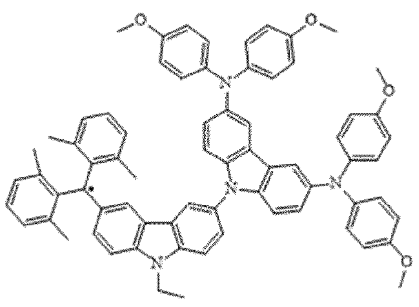
94 .

**2.** Organischer Halbleiter nach Anspruch 1, wobei das Radikal aus der Gruppe der Radikalverbindungen 1)-6) ausgewählt ist:

1) 6-(Bis(2,4-dimethylphenyl)methyl)-3',6'-di-tert-butyl-9-ethyl-9H-3,9'-bicarbazol

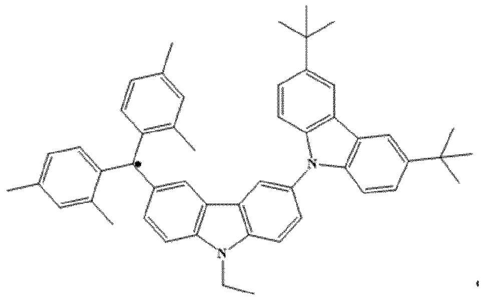

2) 6-Benzhydryl-3',6'-di-tert-butyl-9-ethyl-9H-3,9'-bicarbazol

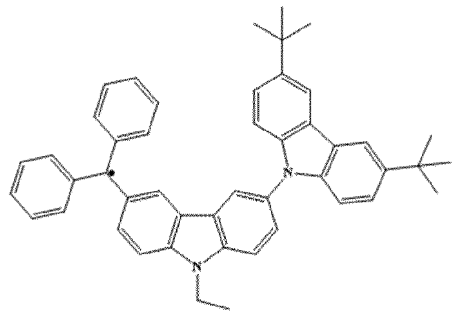

3) 6-(Bis(2,6-dimethylphenyl)methyl)-3',6'-di-tert-butyl-9-ethyl-9H-3,9'-bicarbazol

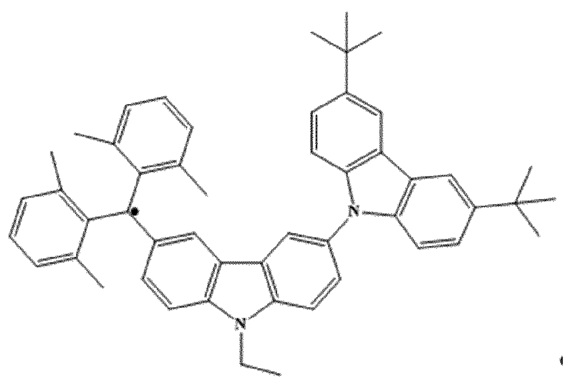

4) 10-(6-(Bis(2,4-dimethylphenyl)methyl)-9-ethyl-9H-carbazol-3-yl)-2,7-di-tert-butyl-9,9-dimethyl-9,10-dihydroacridin

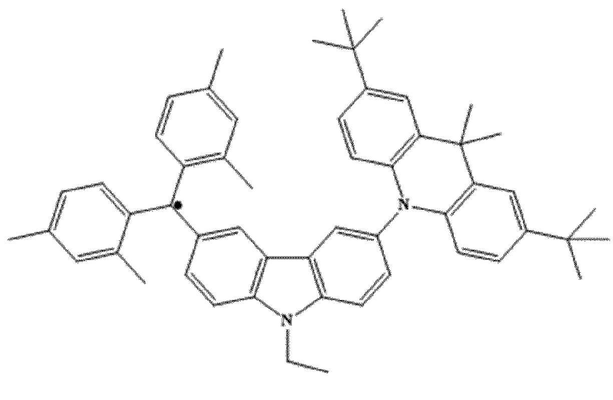

5) 10-(6-Benzhydryl-9-ethyl-9H-carbazol-3-yl)-2,7-di-tert-butyl-9,9-dimethyl-9,10-dihydroacridin

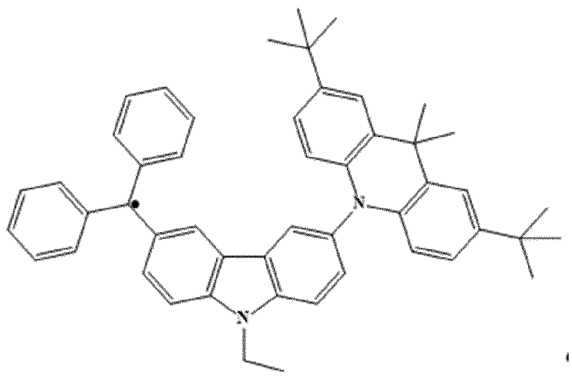

,

6) 10-(6-(Bis(2,6-dimethylphenyl)methyl)-9-ethyl-9H-carbazol-3-yl)-2,7-di-tert-butyl-9,9-dimethyl-9,10-dihydroacridin

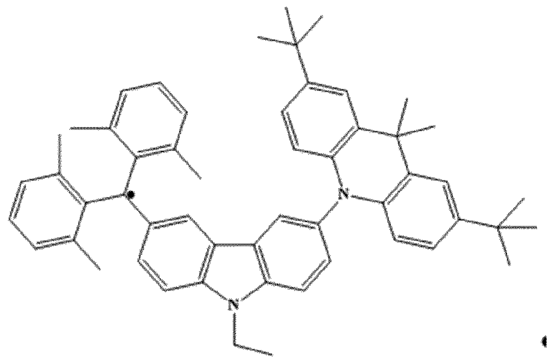

,

**3.** Syntheseverfahren des bipolaren organischen Halbleiters nach einem der Ansprüche 1 bis 2, wobei der Radikalakzeptor, der der allgemeinen Formel (1) entspricht, über eine Friedel-Crafts-Alkylierungsreaktion synthetisiert wird, mit mindestens den folgenden Schritten:

a) aromatisches Amin wird alkyliert durch die Reaktion mit aromatischem Alkohol in Gegenwart einer Lewis-Säure als Katalysator, um das alkylierte aromatische Amin als eine Zwischenverbindung zu erhalten;
b) die anschließende Dehydrierung des alkylierten aromatischen Amins wird durchgeführt durch Zugeben von p-Chloranyl, um ein stabiles freies Radikal zu erhalten; und
c) nach Beendigung der Reaktion wird das Reaktionsgemisch gefiltert und mit Ethylacetat gewaschen;
d) alle flüchtigen Bestandteile werden unter Vakuum entfernt;
e) und die Produkte werden aus Methanol umkristallisiert.

**4.** Verfahren nach Anspruch 3 zur Synthese der bipolaren organischen Halbleiter 1)-6) nach Anspruch 3, das die folgenden Schritte umfasst:

• in dem Schritt a) wird ein aromatisches Amin mit der Formel

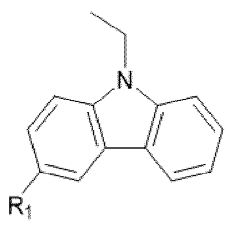

,

wobei $R_1$ für die Halbleiter 1),2),3) Carbazol und für die Halbleiter 4),5),6) Dimethyl-Acridan ist, alkyliert durch die Reaktion mit einem aromatischen Alkohol mit der Formel

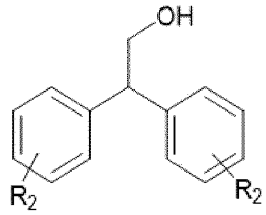

,

wobei $R_2$ für die Halbleiter 1),4) 1,3-Dimethyl-, für die Halbleiter 2),5) H und für die Halbleiter 3),6) 2,4-Dimethyl-ist, in der Anwesenheit einer Lewis-Säure als Katalysator, um das alkylierte aromatische Amin als eine Zwischenverbindung I 1-6 zu erhalten; und

• in dem Schritt b) wird die Dehydrierung des alkylierten aromatischen Amins einer beliebigen der Zwischenverbindungen I 1-6 dazu durchgeführt, ein stabiles freies Radikal zu erhalten, durch die folgenden Teilschritte:

◦ unter Argon-Atmosphäre und im Dunkeln werden die entsprechenden Zwischenverbindungen I 1-6 von 1,00 Äquivalent in 40 ml trockenem THF gelöst;
◦ KOtBu von 2,00 Äquivalenten wird zugegeben, die Lösung färbt sich sofort weinrot;
◦ die Lösung wird 1,5 Stunden lang im Dunkeln bei Raumtemperatur gerührt, dann wird p-Chloranil (2,7 Äquivalente) zugegeben;
◦ die Lösung wurde weitere 1,5 Stunden gerührt, bis die Reaktion abgeschlossen ist.

**5.** Verfahren nach einem der Ansprüche 3 bis 4, ferner umfassend:

• Verwenden der paramagnetischen Elektronenresonanzmethode zum Bestätigen der Radikalform, wobei die Messung der Energieaufnahme, die unter Mikrowellenbestrahlung erzeugt wird und das Magnetfeld ändert, durch Einsetzen eines Spektroskopie-Systems.

**6.** Organische lichtemittierende Vorrichtung (OLED), die eine Donator-Akzeptor-Struktur umfasst, wobei die Donator-Akzeptor-Struktur den organischen Halbleiter nach einem der Ansprüche 1 bis 2 umfasst.

**7.** Verwendung des organischen Halbleiters nach den Ansprüchen 1-2 als elektroaktive Materialien in optoelektronischen Vorrichtungen.

**8.** Verwendung nach Anspruch 7, wobei der bipolare organische Halbeiter ein beliebiges von Emittern, Hosts, ladungstransportierende, ladungsinjizierende, ladungsblockierende oder exzitonblockierende Materialien in einer organischen Leuchtdiode ist.

**9.** Verwendung nach Anspruch 7 als Material in Leuchtdioden basierend auf Perowskiten; wobei die LED im Wesentlichen aus einer Indium-Zinnoxid-Anode, einer Schicht aus PEDOT:PSS als Lochinjektionsschicht und einer Schicht aus Leuchtmaterial auf Perowskit-Basis, einer Elektronentransportschicht aus der/den beanspruchten Verbindung(en) und einer Kathode besteht.

**10.** Verwendung nach Anspruch 7, wobei der bipolare organische Halbleiter ein Absorber und/oder ladungstransportierendes Material in organischen und/oder hybriden Fotodetektoren und Solarzellen ist.

**11.** Verwendung nach Anspruch 7, wobei der bipolare organische Halbleiter ein funktionales Material vertikal konfigurierter organischer Leuchttransistoren (VOLETs) ist.

**12.** Verwendung nach Anspruch 7 in optischen Chemo-Sensoren.

**13.** Verwendung nach Anspruch 7, wobei der bipolare organische Halbleiter aktives Material in Speichervorrichtungen ist.

## Revendications

**1.** Semi-conducteur organique bipolaire de type donneur-accepteur, sélectionné dans le groupe de composés :

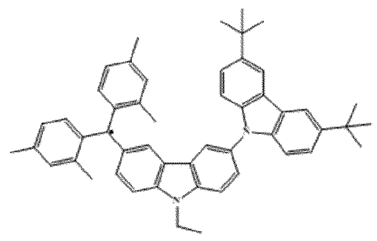
1¶

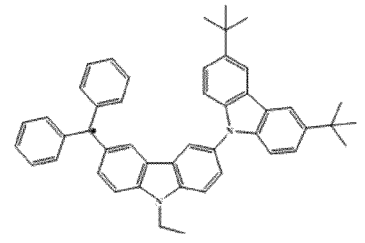
2¶

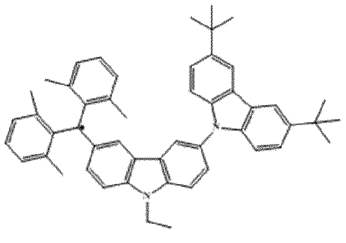
3¶

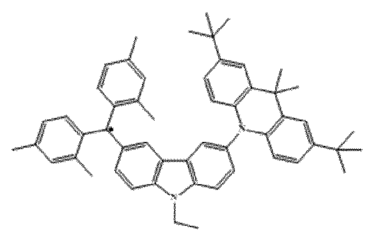
4¶

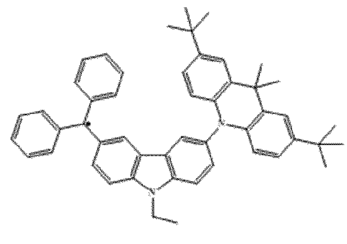
5¶

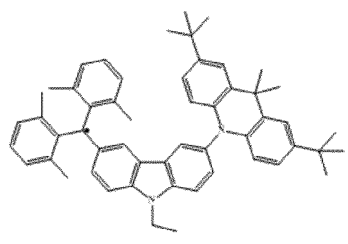
6¶

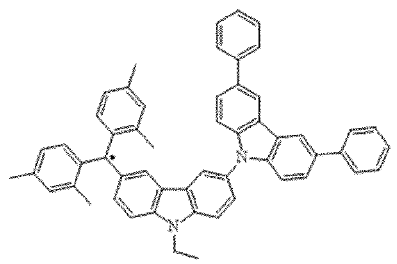
7

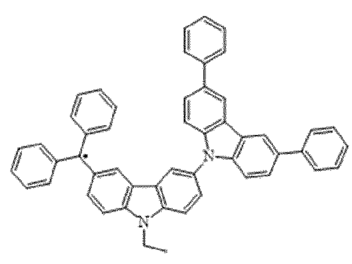
8

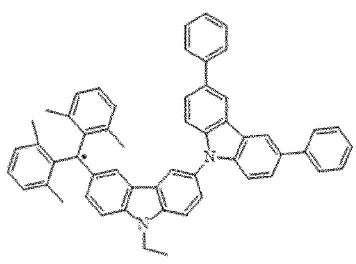
9

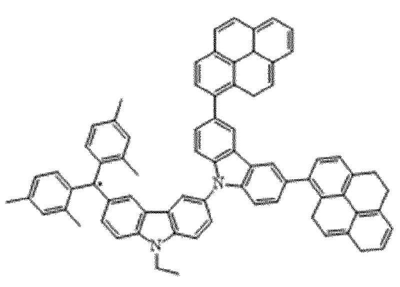
62

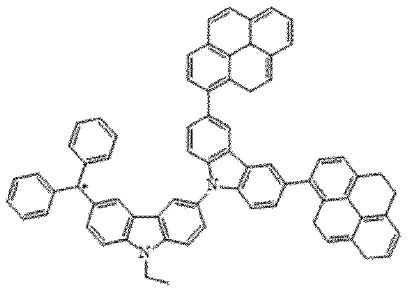
63

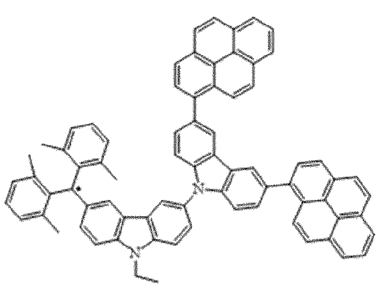
64

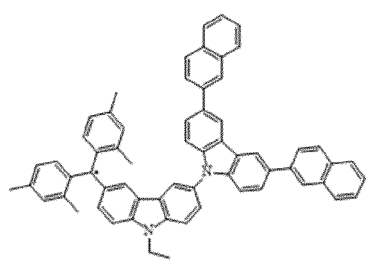
65

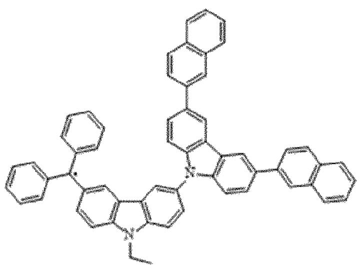
66

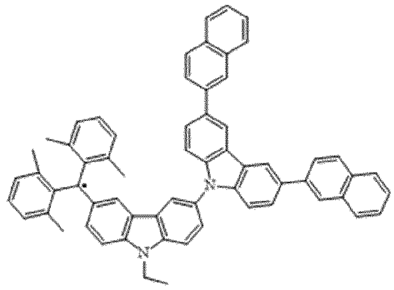
67

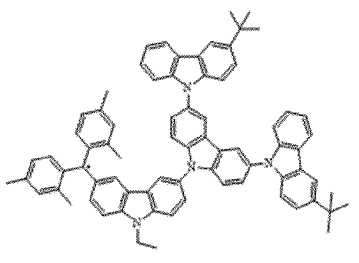
68

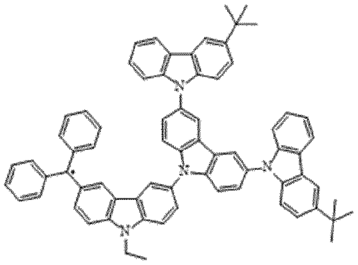
69

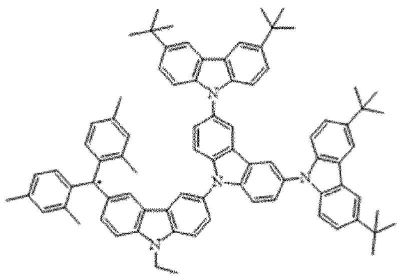
70

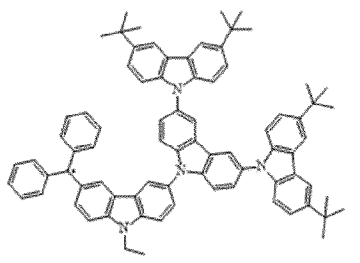
71

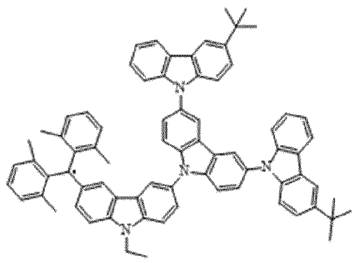
72

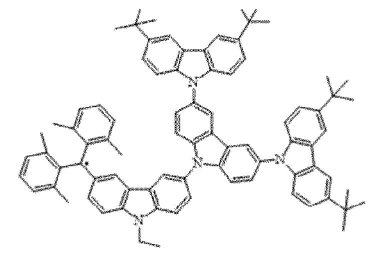
73

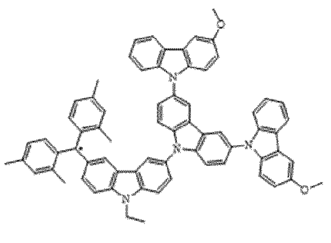
74

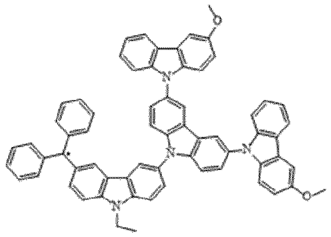
75

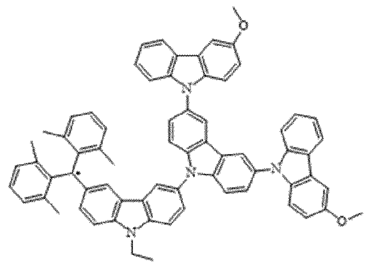
76

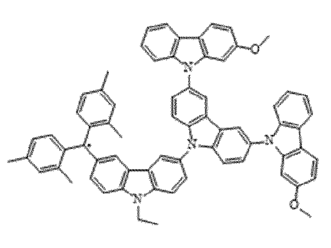
77

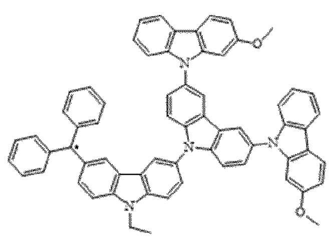
78

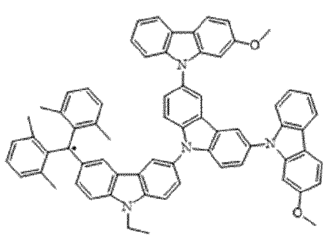
79

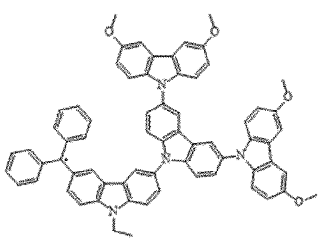
80

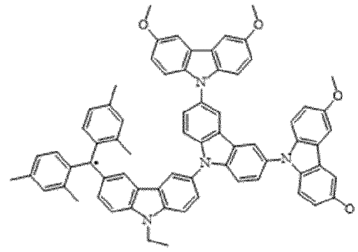
81

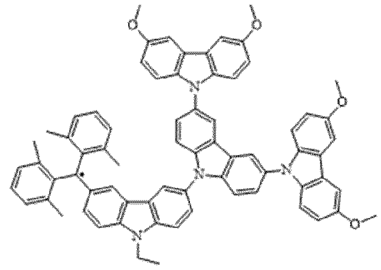
82

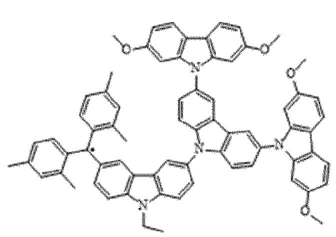
83

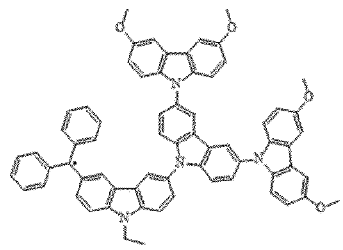
84

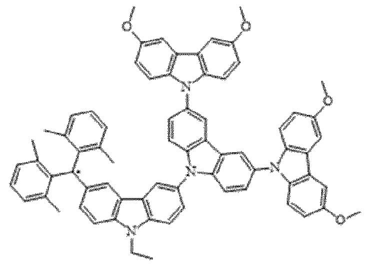
85

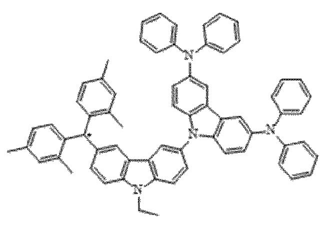
86

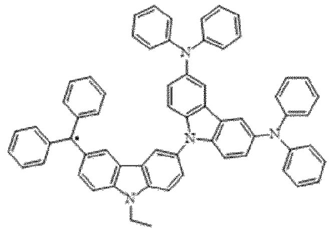
87

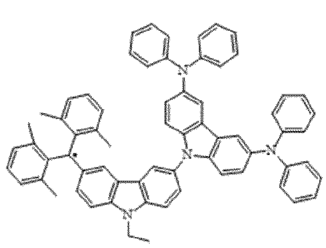
88

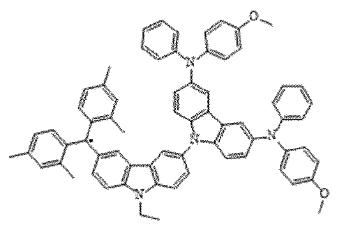
89

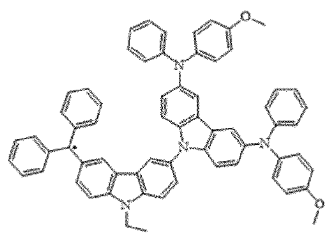
90

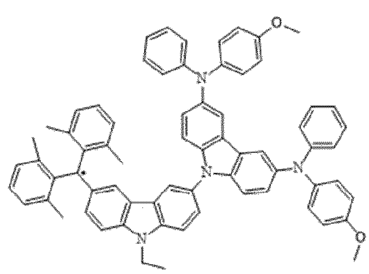
91

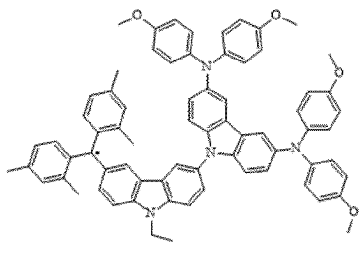
92

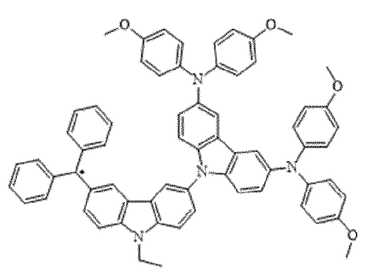
93

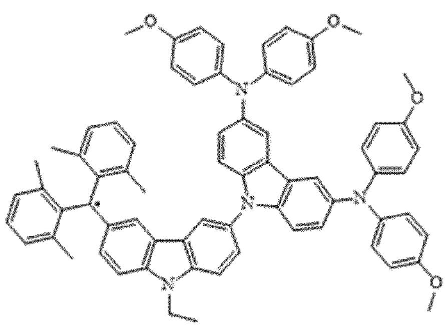
94

.

**2.** Semi-conducteur organique selon la revendication 1, dans lequel le radical est choisi dans le groupe des radicaux des

composés 1) à 6) :

1) 6)-(Bis(2,4-diméthylphényl)méthyl)-3',6'-di-tert-butyl-9-éthyl-9H-3,9'-bicarbazole

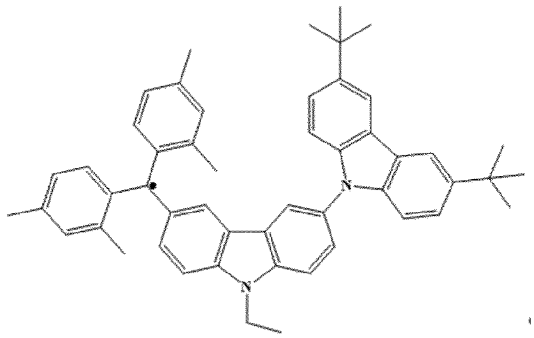

2) 6-Benzhydryl-3',6'-di-tert-butyl-9-éthyl-9H-3,9'-bicarbazole

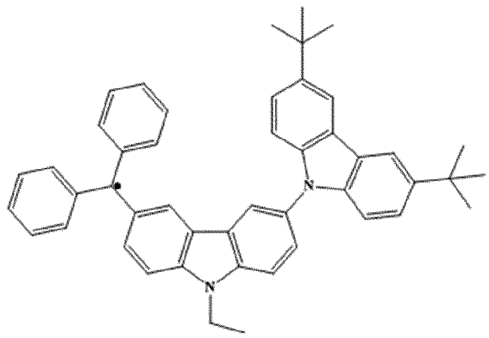

3) 6-(Bis(2,6-diméthylohényl)méthyl)-3',6'-di-tert-butyl-9-éthyl-9H-3,9'-bicarbazole

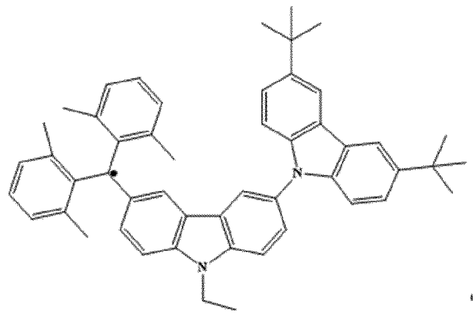

4) 10-(6-(Bis(2,4-diméthylohényl)méthyl)-9-éthyl-9H-carbazol-3-yl)-2,7-di-tert-butyl-9,9-diméthyl-9,10-dihydroacridine

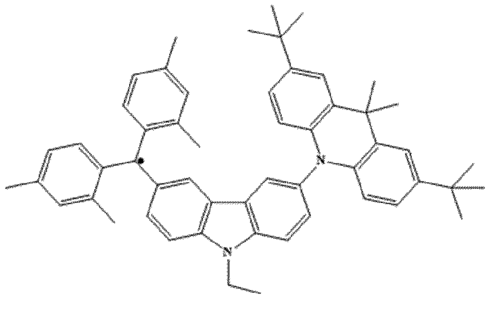

5) 10-(6-Benzhydryl-9-éthyl-9H-carbazol-3-yl)-2,7-di-tert-butyl-9,9-diméthyl-9,10-dihydroacridine

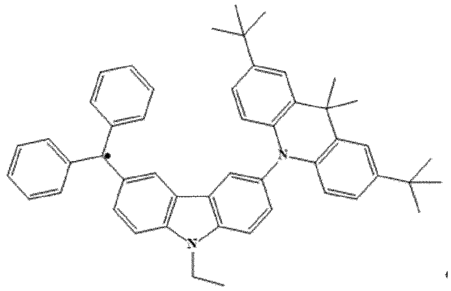

,

6) 10-(6-(Bis(2,6-diméthylohényl)méthyl)-9-éthyl-9H-carbazol-3-yl)-2,7-di-tert-butyl-9,9-diméthyl-9,10-dihydroacridine

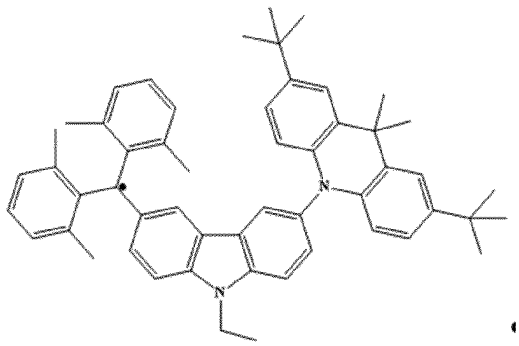

,

**3.** Procédé de synthèse du semi-conducteur organique bipolaire selon l'une quelconque des revendications 1 à 2, dans lequel l'accepteur de radicaux correspondant à la formule générale (I) est synthétisé via une réaction d'alkylation de Friedel-Crafts par au moins les étapes de

a) l'amine aromatique est alkylée par réaction avec un alcool aromatique en présence d'acide de Lewis comme catalyseur, pour obtenir l'amine aromatique alkylée comme composé intermédiaire ;
b) la déshydrogénation suivante de l'amine aromatique alkylée est réalisée en ajoutant du p-chloranyle, pour obtenir un radical libre stable ; et
c) une fois la réaction terminée, le mélange réactionnel est filtré et lavé avec de l'acétate d'éthyle ;
d) tous les volatils sont éliminés sous vide ;
e) et les produits sont recristallisés à partir du méthanol.

**4.** Procédé selon la revendication 3 de synthèse des semi-conducteurs organiques bipolaires 1) à 6) selon la revendication 3, comprenant les étapes de

• à l'étape a), une amine aromatique de formule

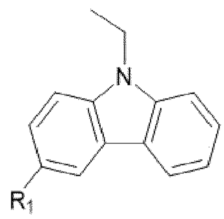

,

dans laquelle $R_1$ est le carbazole pour les semi-conducteurs 1), 2), 3), et le diméthylacridane pour les semi-conducteurs 4), 5), 6), est alkylé par réaction avec un alcool aromatique de formule

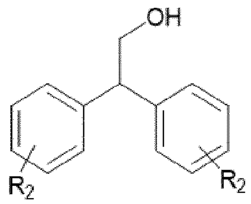

,

dans laquelle $R_2$ est 1,3-diméthyl- pour les semi-conducteurs 1),4), H pour les semi-conducteurs 2),5), et 2,4-diméthyl- pour les semi-conducteurs 3),6), en présence d'acide de Lewis comme catalyseur, pour obtenir l'amine aromatique alkylée comme composé intermédiaire I 1-6 ; et

• à l'étape b), la déshydrogénation de l'amine aromatique alkylée de l'un quelconque desdits composés intermédiaires I1-6 est effectuée, pour obtenir un radical libre stable, par les sous-étapes suivantes :

◦ Sous atmosphère d'argon et dans l'obscurité, les composés intermédiaires correspondants I1-6 de 1,00 eqv sont dissous dans du THF sec de 40 ml ;
◦ 2,00 eqv de KOtBu est ajouté, la solution devient immédiatement colorée en bordeaux ;
◦ La solution est agitée pendant 1,5 h dans l'obscurité à température ambiante, puis du p-chloranile à 2,7 eqv est ajouté ;
◦ La solution a été agitée pendant 1,5 h supplémentaire, jusqu'à ce que la réaction soit terminée.

**5.** Procédé selon l'une quelconque des revendications 3 à 4, comprenant en outre

• l'utilisant de la méthode de résonance paramagnétique électronique pour confirmer la forme radicale dans laquelle la mesure de l'absorption d'énergie générée sous irradiation micro-ondes et la variation du champ magnétique en utilisant un système de spectroscopie.

**6.** Dispositif électroluminescent organique (OLED) comprenant une structure donneur-accepteur, ladite structure donneur-accepteur comprenant le semi-conducteur organique selon l'une quelconque des revendications 1 à 2.

**7.** Utilisation du semi-conducteur organique selon les revendications 1 à 2 comme matériaux électroactifs dans des dispositifs optoélectroniques.

**8.** Utilisation selon la revendication 7, dans laquelle le semi-conducteur organique bipolaire est l'un quelconque des émetteurs, hôtes, matériaux de transport de charge, d'injection de charge, de blocage de charge ou de blocage d'excitons dans une diode électroluminescente organique.

**9.** Utilisation selon la revendication 7 comme matériau dans des diodes électroluminescentes à base de pérovskites ; la LED étant constituée essentiellement d'une anode en oxyde d'indium-étain, d'une couche de PEDOT:PSS comme couche d'injection de trous, et d'une couche de matériau électroluminescent à base de pérovskite, d'une couche de transport d'électrons du ou des composés revendiqués et d'une cathode.

**10.** Utilisation selon la revendication 7, dans laquelle le semi-conducteur organique bipolaire est un matériau absorbant et/ou transporteur de charge dans des photodétecteurs organiques et/ou hybrides et des cellules solaires.

**11.** Utilisation selon la revendication 7, dans laquelle le semi-conducteur organique bipolaire est un matériau fonctionnel de transistors électroluminescents organiques configurés verticalement (VOLET).

**12.** Utilisation selon la revendication 7 dans des chimio-capteurs optiques.

**13.** Utilisation selon la revendication 7, dans laquelle le semi-conducteur organique bipolaire est un matériau actif dans des dispositifs de mémoire.

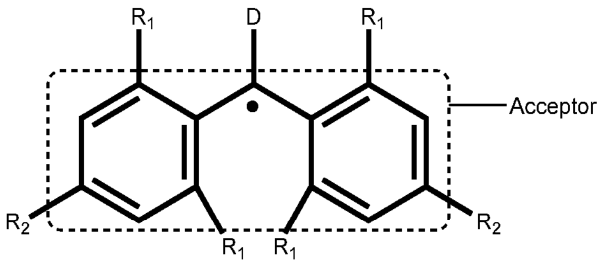


**$R_1$, $R_2$:** aliphatic or halogen substituents.

**a)**

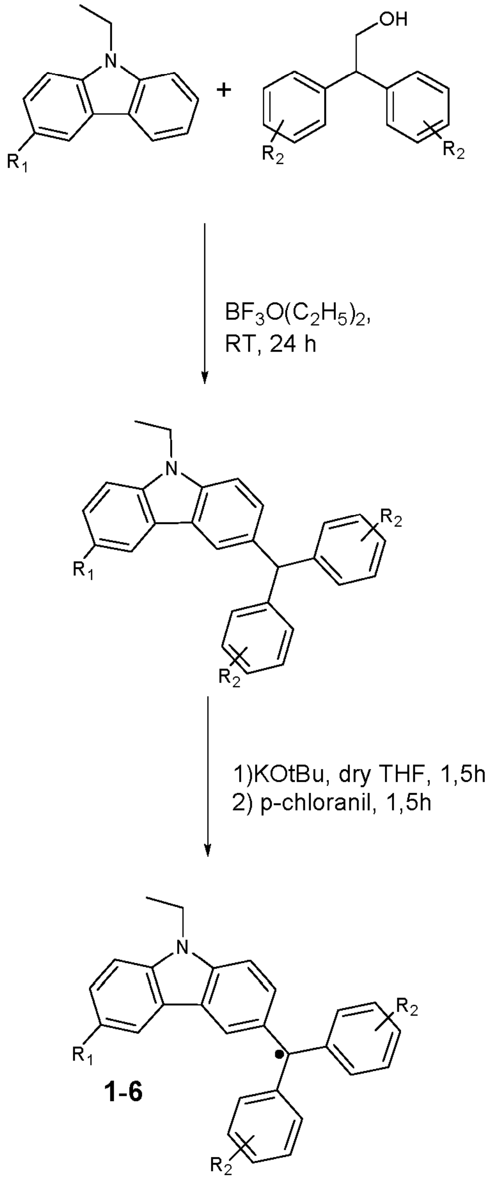


**1-6**

**1** $R_1$=Carbazole, $R_2$=1,3-dimehtyl-;
**2** $R_1$=Carbazole, $R_2$=H;
**3** $R_1$=Carbazole, $R_2$= 2,4-dimethyl-;
**4** $R_1$=Dimethylacridane, $R_2$=1,3-dimehtyl-;
**5** $R_1$=Dimethylacridane, $R_2$=H;
**6** $R_1$=Dimethylacridane, $R_2$= 2,4-dimethyl-.

**b)**
**Figure 1**

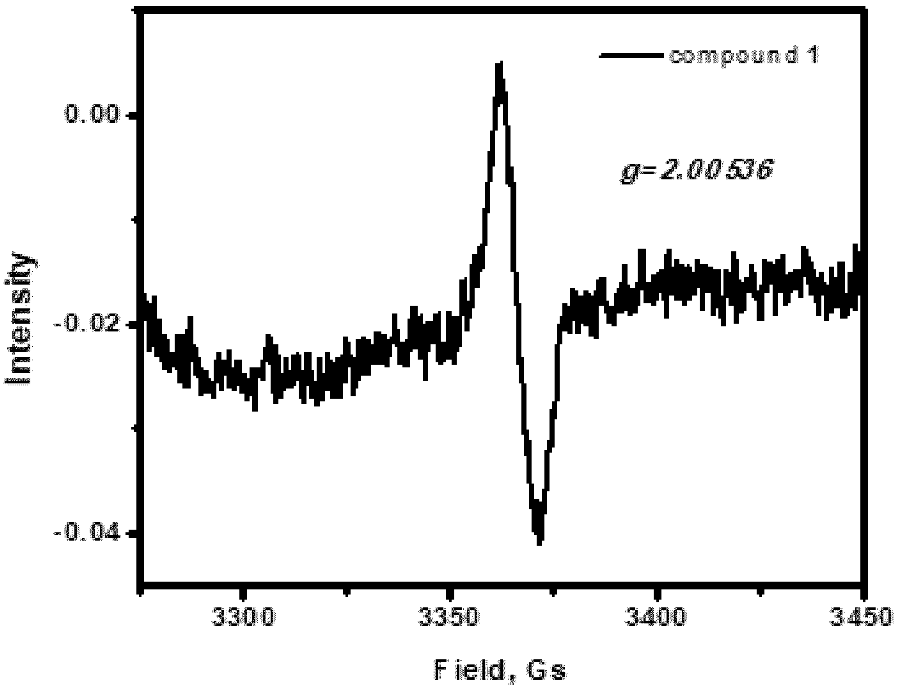
compound 1
g= 2.00536
Intensity
0.00
-0.02
-0.04
3300
3350
3400
3450
Field, Gs

a)

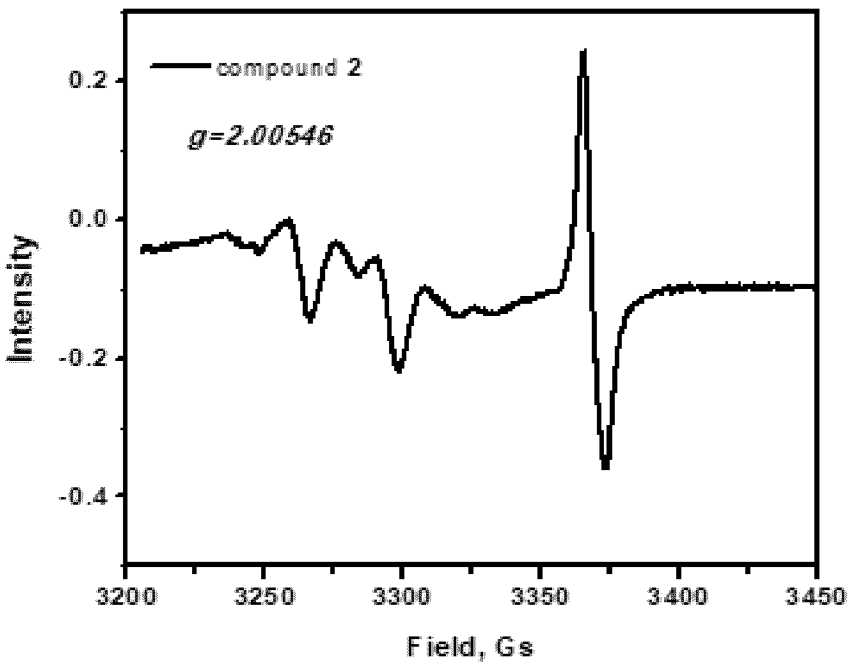
compound 2
g=2.00546
Intensity
0.2
0.0
-0.2
-0.4
3200
3250
3300
3350
3400
3450
Field, Gs

b)

Figure 2

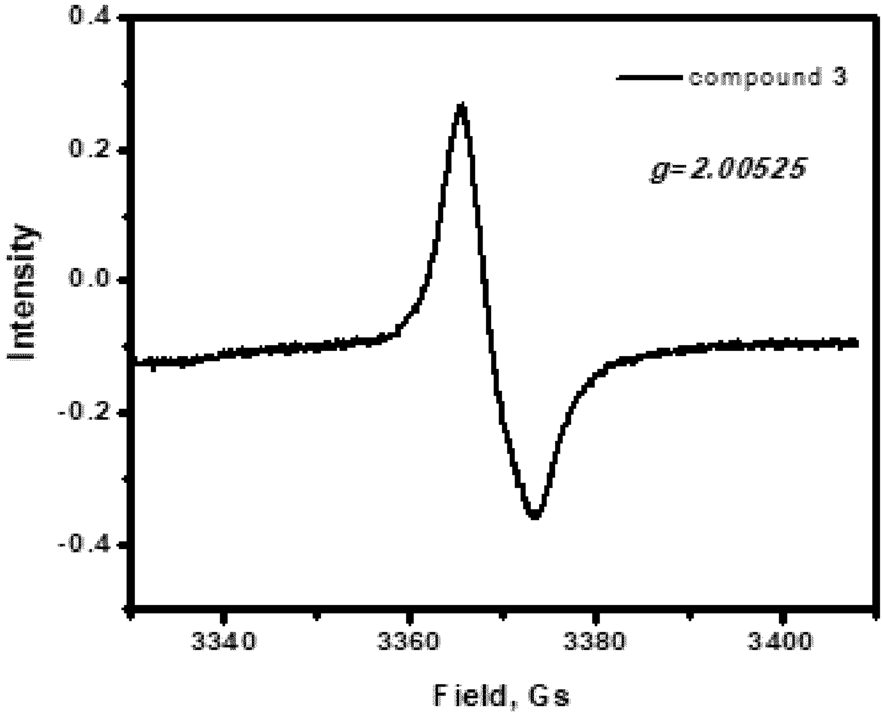
compound 3
g=2.00525
Intensity
Field, Gs
0.4
0.2
0.0
-0.2
-0.4
3340
3360
3380
3400

c)

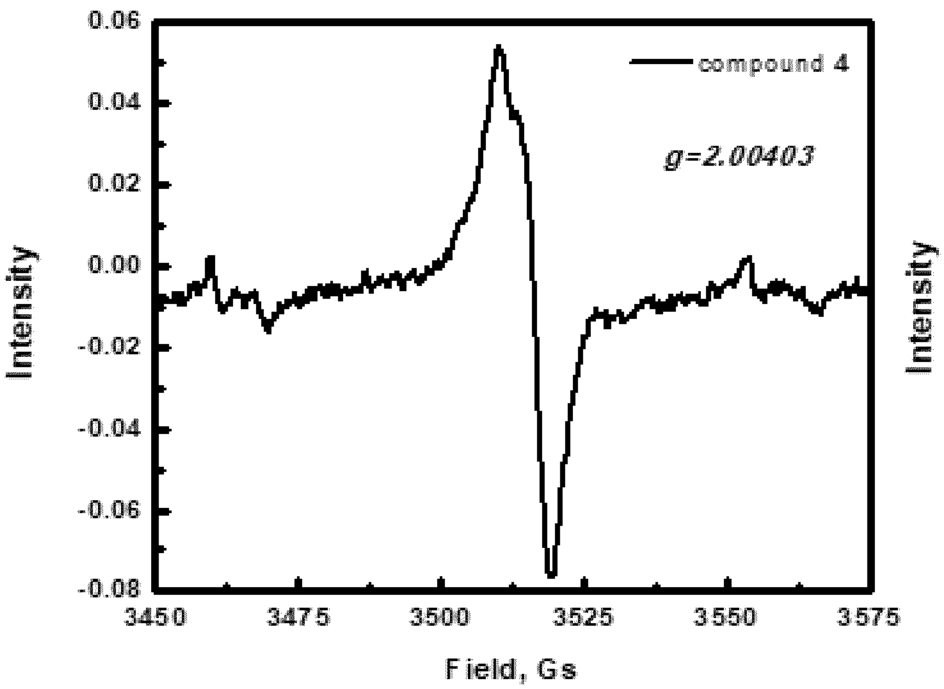
compound 4
g=2.00403
Intensity
Intensity
Field, Gs
0.06
0.04
0.02
0.00
-0.02
-0.04
-0.06
-0.08
3450
3475
3500
3525
3550
3575

d)

Figure 2

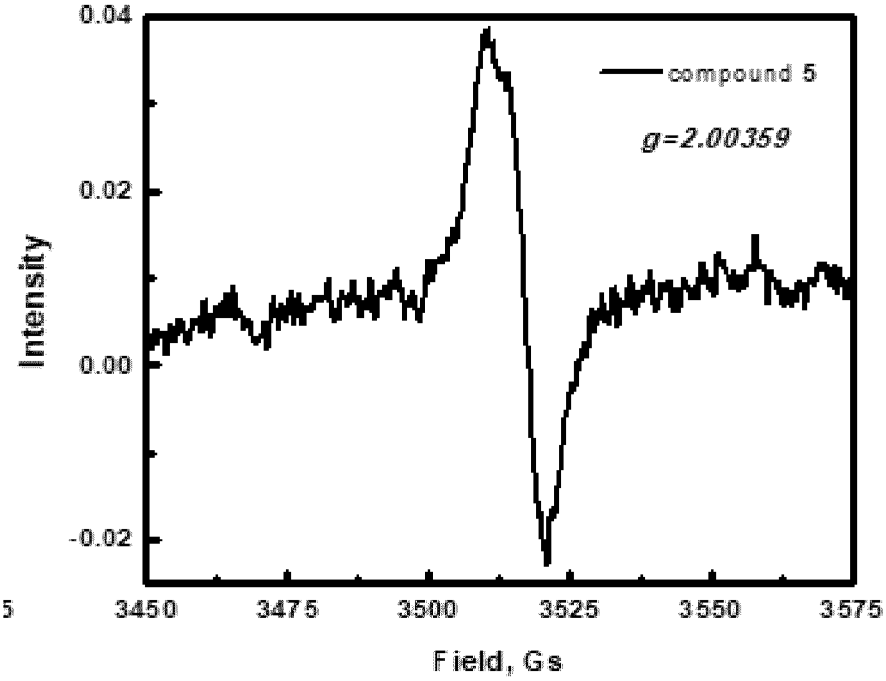
compound 5
g=2.00359
Intensity
Field, Gs

e)

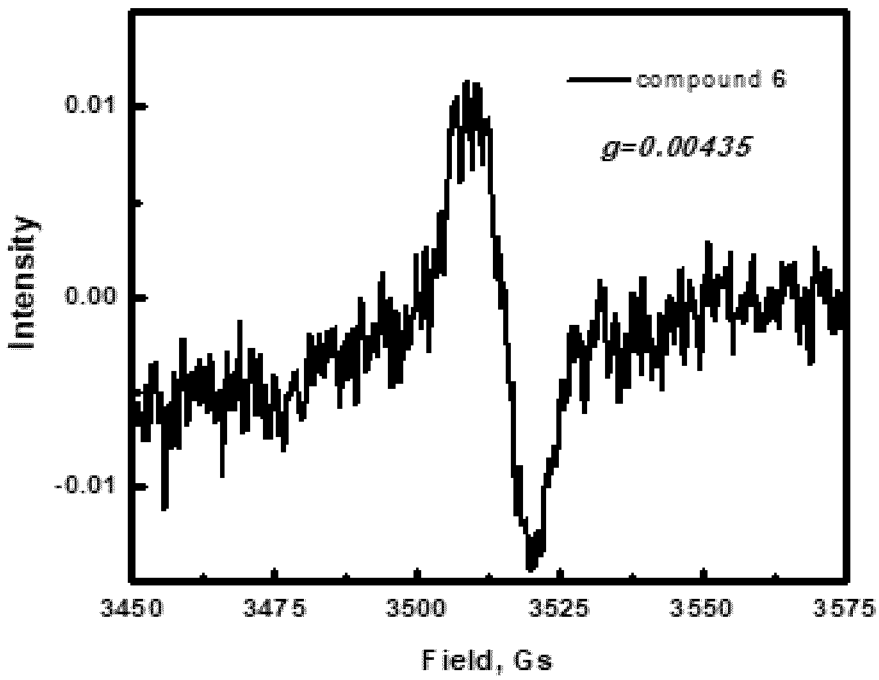
compound 6
g=0.00435
Intensity
Field, Gs

f)

Figure 2

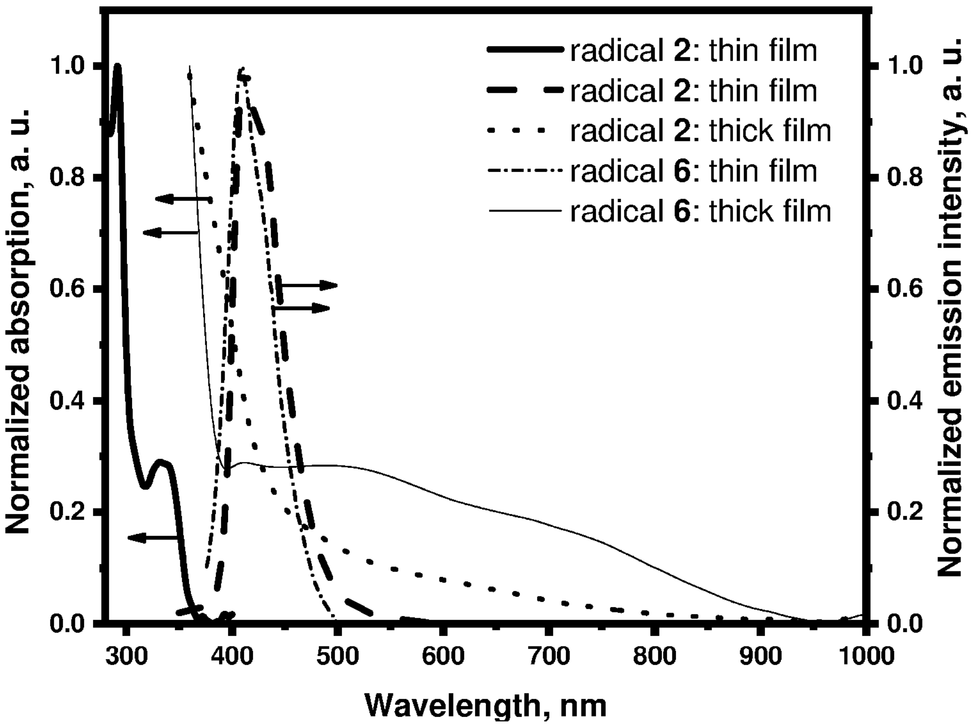
radical 2: thin film
radical 2: thin film
radical 2: thick film
radical 6: thin film
radical 6: thick film
Normalized absorption, a. u.
Normalized emission intensity, a. u.
Wavelength, nm
0.0
0.2
0.4
0.6
0.8
1.0
300
400
500
600
700
800
900
1000

a)

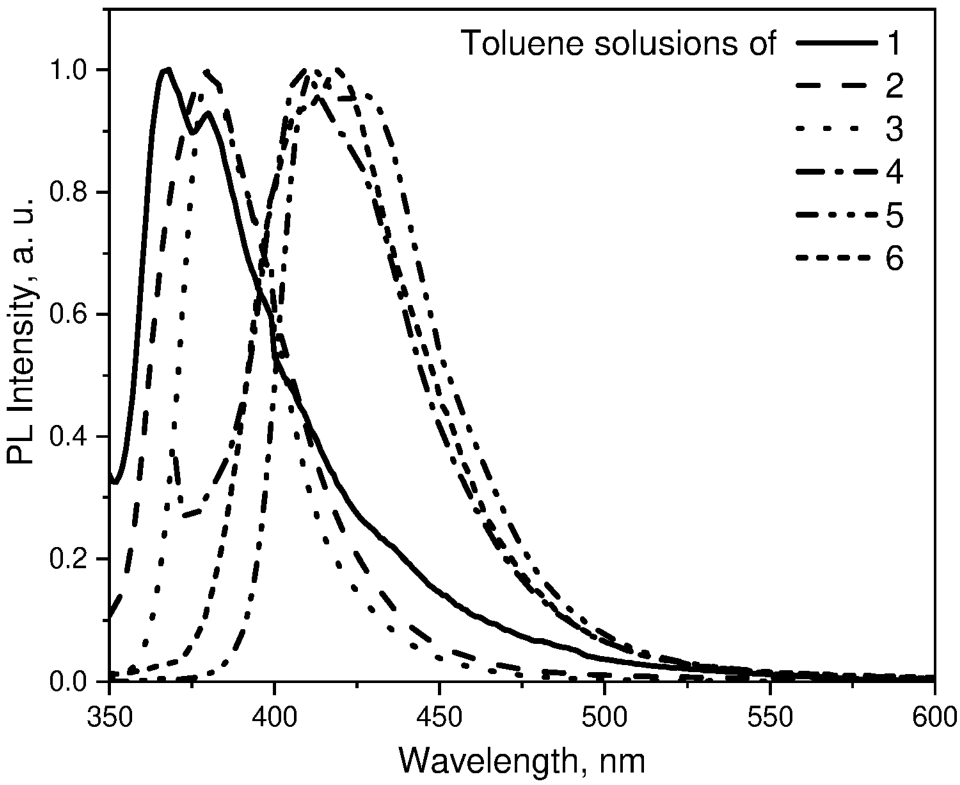
Toluene solusions of
1
2
3
4
5
6
PL Intensity, a. u.
Wavelength, nm
0.0
0.2
0.4
0.6
0.8
1.0
350
400
450
500
550
600

b)

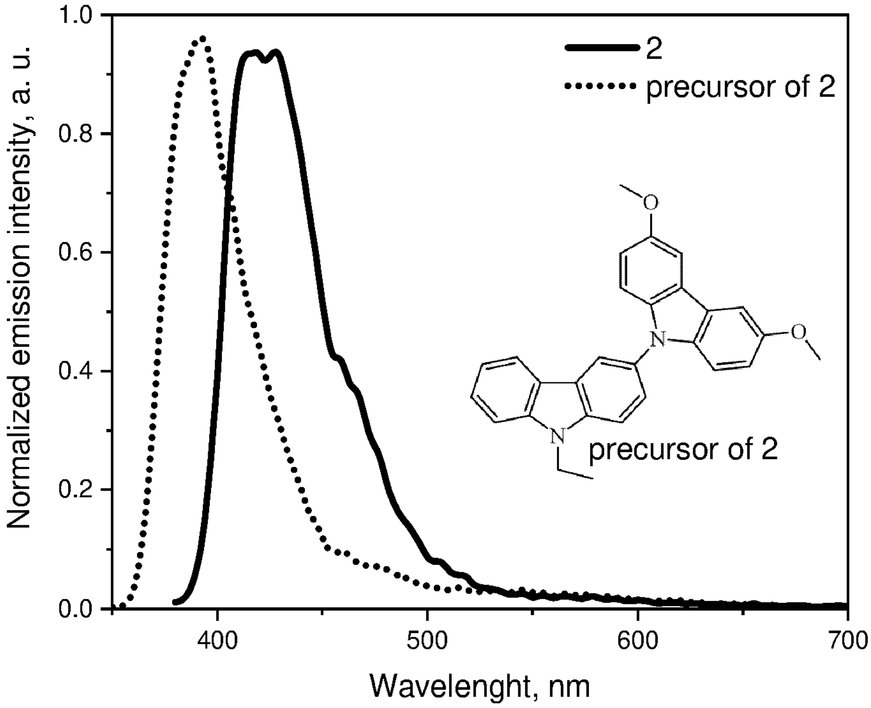
1.0
0.8
0.6
0.4
0.2
0.0
Normalized emission intensity, a. u.
400
500
600
700
Wavelenght, nm
2
precursor of 2
precursor of 2

**c)**

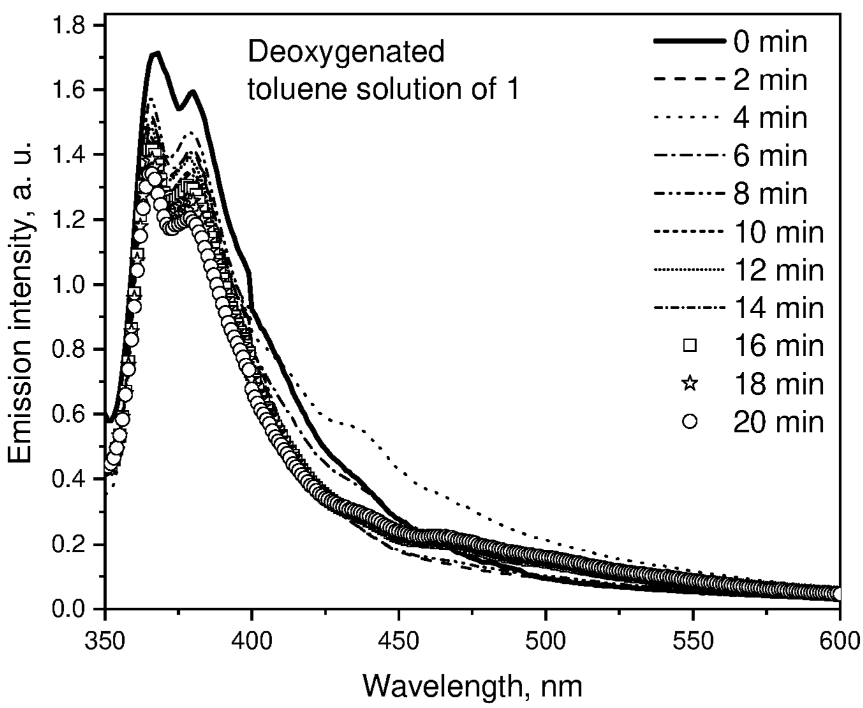
1.8
1.6
1.4
1.2
1.0
0.8
0.6
0.4
0.2
0.0
Emission intensity, a. u.
350
400
450
500
550
600
Wavelength, nm
Deoxygenated
toluene solution of 1
0 min
2 min
4 min
6 min
8 min
10 min
12 min
14 min
16 min
18 min
20 min

**d)**

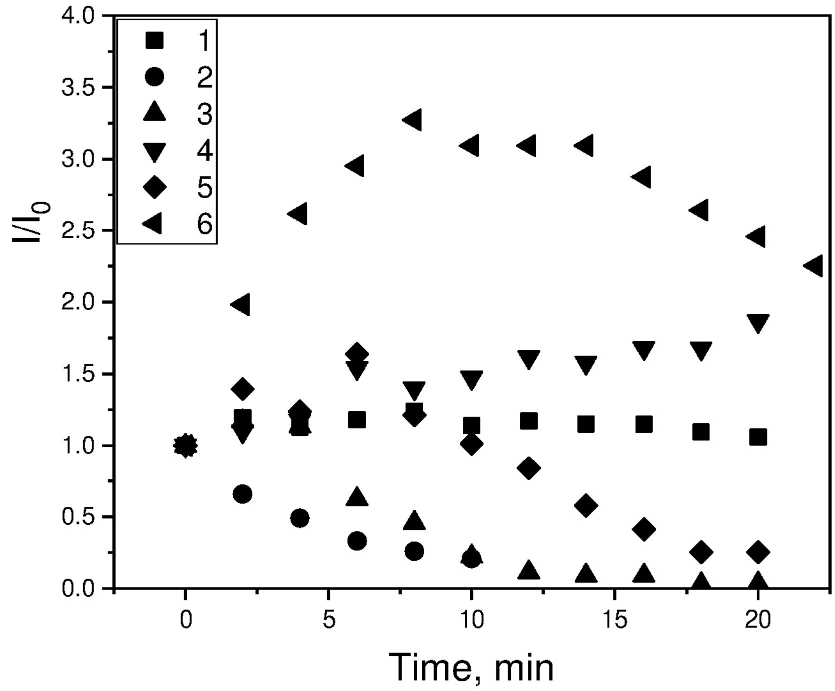


e)

Figure 3

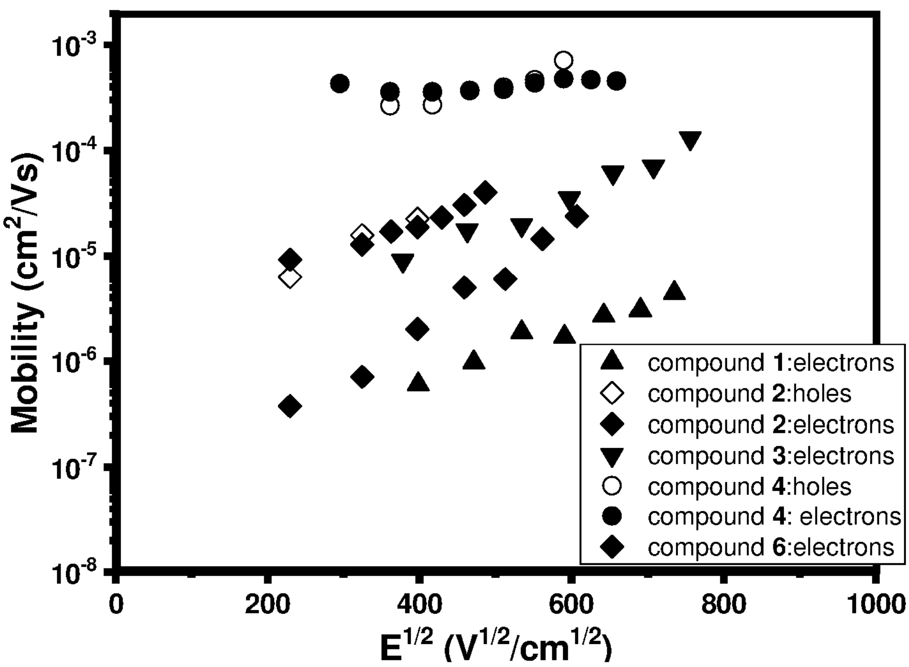


Figure 4

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- CN 108191739 A

### Non-patent literature cited in the description


- *Nat. Photon.*, 2014, vol. 8, 326-332
- *ACS Appl. Mater. Interfaces*, 2016, vol. 8, 23190-23196
- *Cryst. Growth Des.*, 2021, vol. 21 (2), 1062-1076
- *Angew.Chem. Int.Ed*, 2015, vol. 54, 7091-7095
- *Angew.Chem.*, 2015, vol. 127, 7197-7201
- *Nature Materials*, 2020, vol. 19, 1224-1229, https://doi.org/10.1038/s41563-020-0705-9
- *Nature*, 2018, vol. 563, 536-540
- **R.H. FRIEND**. *Nature*, 2018, vol. 563, 536-540
- *Nat. Mater.*, 2019, vol. 18, 917-918
- *Nature Materials*, 2020, vol. 18, 977-984
- *CCS Chem.*, 2020, vol. 2, 1129-1145
- *J. Appl. Phys.*, 2021, vol. 129, 180901
- *J. Phys. Chem. C*, 2009, vol. 113, 20958-20966
- *Mater. Chem. Front.*, 2017, vol. 1, 2132-2135
- *Chem. Commun.*, 2016, vol. 52, 13393-13396
- *J.Org. Chem.*, 1998, vol. 63, 9992-9994
- *Org. Biomol. Chem.*, 2007, vol. 5, 1321-1338
- *Chem. Rev.*, 2003, vol. 103, 789-809
- *Adv. Mater.*, 2020, vol. 32, 1908015
- *ACS Appl. Mater. Interfaces*, 2013, vol. 5, 9896-9901
- *Adv. Mater.*, 2013, vol. 25, 6951-6955
- *J. Am. Chem. Soc.*, 2020, vol. 142, 38-43
- *J. Am. Chem. Soc.*, 2017, vol. 139 (41), 14336-14339
- *J. Am. Chem. Soc.*, 2014, vol. 136, 14658-14661
- *Chem. Commun.*, 2010, vol. 46, 5130-5132
- *Org. Lett.*, 2019, vol. 21, 4448-4453
- *Chem. Mater.*, 2017, vol. 29 (16), 6733-6739
- *Adv. Funct. Mater.*, 2021, vol. 31, 2101981
- *Nanoscale Adv.*, 2020, vol. 2, 1031-1035
- *ACS Appl. Mater. Interfaces*, 2021, vol. 13 (28), 33311-33320
- *J. Am. Chem. Soc.*, 1971, vol. 93, 2215-2225
- *Angewandte Chemie International*, vol. 43 (5), 550-556
- *Angew. Chem. Int. Ed.*, 2018, vol. 57, 2869-2873
- *Adv. Mater.*, 2013, vol. 25, 5372-5391
- *J. Lumin.*, 2002, vol. 97, 83-10192
- *Org. Electron.*, 2019, vol. 70, 227-239
- *Org. Electron.*, 2009, vol. 10, 158-162
- *J. Org. Chem.*, 2014, vol. 79, 1771-1777
- *Nat. Commun.*, 2022, vol. 13, 5367
- *Nature Materials*, 2020, vol. 19, 1224-1229
- *Chem. Eur. J.*, 2016, vol. 22, 18551-18558
- *J Phys Org Chem.*, 2019, vol. 32, e3974
- *Nat. Commun.*, 2015, vol. 6, 8476